# EUROPEAN PATENT APPLICATION

(11) **EP 4 665 115 A2**
(43) Date of publication of application: **17.12.2025**
(21) Application number: 25212109.0
(22) Date of filing: 29.10.2025
(51) Int. Cl.: H10F 19/90, H10F 77/20

(54) **BACK-CONTACT SOLAR CELL AND BACK-CONTACT PV MODULE HAVING THE SAME**

(30) Priority: 20.08.2025 CN 202511174062
(71) Applicant: Tongwei Solar (Chengdu) Co., Ltd., Chengdu, Sichuan 610299 (CN)
(72) Inventor: FAN, Jianbin, Chengdu, 610299 (CN); ZHU, Jiang, Chengdu, 610299 (CN); TAN, Xiaochun, Chengdu, 610299 (CN); LI, Zhonglan, Chengdu, 610299 (CN); MENG, Xiajie, Chengdu, 610299 (CN)
(74) Representative: Michalski Hüttermann & Partner Patentanwälte mbB

(57) **Abstract**

A back-contact solar cell includes a back-contact solar cell body, solder pad groups, and fingers. Solder pad groups of two polarities are alternately spaced apart on a back surface of the back-contact solar cell body; each solder pad group includes a plurality of solder pads spaced apart. Fingers of two polarities are arranged on the back surface of the back-contact solar cell body, and each solder pad is connected to at least one finger of the same polarity and spaced apart from fingers of opposite polarity. The back-contact solar cell body has two first solar cell edges arranged opposite to each other. A spacing between the edge solder pad and the closest first solar cell edge is D1, a length of the back-contact solar cell body in the first direction is D2, and 0.043% < D1/D2 < 0.870%.

## Description

### TECHNICAL FIELD

The present disclosure relates to the field of solar cell technology, and more particularly to a back-contact solar cell and a back-contact photovoltaic (PV) module having the back-contact solar cell.

### BACKGROUND

Edge regions of conventional back-contact solar cells suffer from poor current collection, which in turn affects the conversion efficiency of the back-contact solar cell and results in a decrease in the output power of the back-contact PV module having the back-contact solar cell.

### SUMMARY

Embodiments of the present disclosure disclose a back-contact solar cell and a back-contact PV module, which can improve the conversion efficiency of the back-contact solar cell.

To achieve the above objectives, in a first aspect, embodiments of the present disclosure disclose a back-contact solar cell, including a back-contact solar cell body, a plurality of solder pad groups, and a plurality of fingers. The plurality of solder pad groups of two polarities are alternately spaced apart along a first direction on a back surface of the back-contact solar cell body. Each solder pad group includes a plurality of homopolar solder pads spaced apart along a second direction. The first direction intersects with the second direction. The plurality of fingers of two polarities are arranged on the back surface of the back-contact solar cell body. Each solder pad is connected to at least one homopolar finger and spaced apart from heteropolar fingers. The back-contact solar cell body has two first solar cell edges arranged opposite to each other along the first direction. A solder pad in the plurality of solder pad groups closest to each first solar cell edge is defined as an edge solder pad. A spacing between the edge solder pad and the closest first solar cell edge is D1, and a length of the back-contact solar cell body in the first direction is D2, and 0.043% < D1/D2 < 0.870%.

In an embodiment, 0.1 mm < D1 < 2 mm.

In an embodiment, 0.1 mm < D1 < 1 mm.

In an embodiment, the edge solder pad and the fingers arranged at edges of the back-contact solar cell form a direct electrical connection.

In an embodiment, only an end of the edge solder pad away from the closest first solar cell edge is connected to the finger along the first direction.

In an embodiment, on the back surface of the back-contact solar cell body, a region between the edge solder pad and the closest first solar cell edge is a gridline-free region.

In an embodiment, the back-contact solar cell further includes a plurality of busbars extending along the second direction. Each busbar is connected to all of the solder pads in each solder pad group; or, each busbar is connected to part of the solder pads in each solder pad group.

In an embodiment, the back-contact solar cell is a busbar -free solar cell.

In an embodiment, when the back-contact solar cell further includes the plurality of busbars, a total orthographic projection area of the busbars and the solder pads on the back-contact solar cell body is S1, an area of the back surface of the back-contact solar cell body is S2, and 0.05% ≤ S1/S2 ≤ 6.2%.

In an embodiment, when the back-contact solar cell is the busbar-free solar cell, a total orthographic projection area of the solder pads on the back-contact solar cell body is S1, the area of the back surface of the back-contact solar cell body is S2, and 0.05% ≤ S1/S2 ≤ 6.2%.

In an embodiment, each finger extends along the first direction, and the plurality of fingers of two polarities are arranged alternately in a column along the second direction.

In an embodiment, a plurality of columns of the fingers are spaced apart along the first direction, and a discontinuity region is provided between adjacent columns of the fingers.

In an embodiment, except for the edge solder pads at edges of the back-contact solar cell, each of the remaining solder pad groups is located in each discontinuity region, and the solder pads included in the remaining solder pad groups are defined as inner solder pads.

In an embodiment, on both sides of each discontinuity region, the fingers having the same polarity as the inner pad are defined as the homopolar fingers. Overlapping notches are provided between two adjacent homopolar fingers along the first direction, and each inner solder pad is located in each overlapping notch, and both ends of the inner pad overlaps with the two homopolar fingers, respectively.

In an embodiment, on both sides of each discontinuity region, the fingers having the opposite polarity with the inner pad are defined as heteropolar fingers, and an isolating notch is provided between two adjacent heteropolar fingers along the first direction.

In an embodiment, a width of the isolating notch W1 is greater than the width of the overlapping notch W2 along the first direction.

In an embodiment, 0.3mm≤W1≤1.2mm; and/or, 0.15 mm≤W2≤0.7 mm.

In an embodiment, the solder pads have a shape selected from a group consisting of a square, a diamond, an oval, a H-shape, a T-shape, or a trapezoid; and/or,
a number of the solder pad groups is greater than or equal to 30 and less than or equal to 120; and/ or,
a spacing between two adjacent solder pad groups is D3, and 1.5 mm ≤ D3 ≤ 8 mm.

In a second aspect, embodiments of the present disclosure discloses a back-contact PV module, including a plurality of back-contact solar cells and a plurality of solder strips. The plurality of back-contact solar cells are electrically connected to each other. At least one of the plurality of back-contact solar cells is the back-contact solar cell according to the first aspect. Each solder strip is soldered to each solder pad groups. The solder strips soldered to the edge solder pads is defined as an edge solder strips. A spacing between the edge solder strip and the first solar cell edge is D4, and 0.043% < D4/D2 < 0.870%.

In an embodiment, 0.1 mm < D4 < 2 mm.

In an embodiment, 0.1 mm < D4 < 1 mm.

In an embodiment, the back-contact solar cell body has two second solar cell edges opposite to each other along the second direction, a solder position of the solder strip closest to the second solar cell edge is defined as a starting solder point.

In an embodiment, a spacing between the starting solder point and the closest second solar cell edge is D5, and 0.5 mm ≤ D5 ≤ 7mm.

In a third aspect, embodiments of the present disclosure disclose a back-contact PV module, including a plurality of back-contact solar cells and a plurality of solder strips. The plurality of back-contact solar cells are electrically connected to each other. At least one of the plurality of back-contact solar cells is the back-contact solar cell according to the first aspect. Each solder strip is soldered to each solder pad group. Each solder pad group is spaced apart from an adjacent finger of opposite polarity along the first direction, and no insulating adhesive is provided between the solder pad group and the adjacent finger of opposite polarity.

In an embodiment, each finger extends along the first direction, and the plurality of fingers of two polarities are arranged alternately in a column along the second direction.

In an embodiment, a plurality of columns of the fingers are spaced apart along the first direction, and a discontinuity region is provided between adjacent columns of the fingers.

In an embodiment, except for the edge solder pads, each of the remaining solder pad groups is located in each discontinuity region, and the solder pads included in the remaining pad groups are defined as inner solder pads.

In an embodiment, on both sides of each discontinuity region, the fingers having the opposite polarity with the inner pad are defined as heteropolar fingers, and an isolating notch is provided between two adjacent heteropolar fingers along the first direction.

In an embodiment, a width of the isolation notch is W1, and a width of the solder strip is W3 along the first direction, and W1>W3.

In a fourth aspect, embodiments of the present disclosure discloses a back-contact PV module, including a plurality of back-contact solar cells and a plurality of solder strips. The plurality of back-contact solar cells are electrically connected to each other. At least one of the plurality of back-contact solar cells is the back-contact solar cell according to the first aspect. Each solder strip is soldered to each solder pad group. In a solder region between the solder strip and the solder pad, in a direction away from the back-contact solar cell body, the back-contact solar cell further includes a solder pad, a Ag-Sn alloy layer, a first Sn-Pb alloy layer, a conductive metal-Sn alloy layer, a conductive metal layer, and a second Sn-Pb alloy layer that are on stacked the back-contact solar cell body sequentially. The Ag-Sn alloy layer has a thickness of T1, and the second Sn-Pb alloy layer has a thickness of T2, and 2.5 < T2 / T1 < 300.

In an embodiment, T1 is in a range from 0.1 µm to 10 µm; and/or,
the first Sn-Pb alloy layer does not contain Bi; and/ or,
the conductive metal layer is made of at least one material selected from a group consisting of Cu and Al.

In an embodiment, each finger extends along the first direction, and the plurality of fingers of two polarities are arranged alternately in a column along the second direction. A plurality of columns of the fingers are spaced apart along the first direction, and a discontinuity region is provided between adjacent columns of the fingers.

In an embodiment, except for the edge solder pads, each of the remaining solder pad groups is located in each discontinuity region, and the solder pads included in the remaining solder pad groups are defined as inner solder pads.

In an embodiment, on both sides of each discontinuity region, the fingers having the same polarity as the inner pad are defined as homopolar fingers. An overlapping notch is provided between two homopolar fingers, each inner solder pad is located in each overlapping notch along the first direction, and both ends of the inner solder pad overlap with the two homopolar fingers. Along the first direction, a width of the overlapping notch is W2, and a width of the solder strip of W3, and W2>W3.

In the back-contact solar cell of the present disclosure, the plurality of solder pad groups of two polarities are arranged alternately spaced apart along the first direction on the back surface of the back-contact solar cell body. Each solder pad group includes a plurality of solder pads of the same polarity arranged along the second direction. Each solder pad is connected to at least one finger of the same polarity and spaced apart from fingers of opposite polarity. As such, the solder pad and the finger connected to the solder pad can be distributed on the back surface of the back-contact solar cell body along the first direction and the second direction, which is conducive to achieve better collection capability and transportation capability for the charge carriers generated in the back-contact solar cell body.

Accordingly, a spacing between the edge solder pad and the closest first solar cell edge is D1, and a length of the back-contact solar cell body in the first direction is D2, and 0.043% < D1/D2 < 0.870%.

When D1/D2 meets the aforementioned ratio, the spacing between the edge solder pad and the closest first solar cell edge is sufficiently small, allowing the finger connected to the edge solder pad to be sufficiently close to the first solar cell edge. This contributes to enlarging the carrier collection region of the finger and contributes to shortening the transportation pathway of the charge carriers generated close to the first solar cell edges to reach the edge solder pads. The shorter the transportation pathway, the smaller the series resistance power loss caused by the resistance in the back-contact solar cell body, and the higher the conversion efficiency of the back-contact solar cell.

Further, the spacing between the edge solder pad and the closest first solar cell edge is not too small, leaving sufficient printing engineering margin for edge solder pad and reducing the risk of edge solder pad being printed outside the back-contact solar cell body.

As such, the back-contact solar cell can achieve a high conversion efficiency and achieve a reduced risk resulted from printing anomalies of edge solder pad.

### BRIEF DESCRIPTION OF THE DRAWINGS

To illustrate the technical solutions in the embodiments of the present disclosure more clearly, the following briefly describes the figures presented in the embodiments. Obviously, the figures described below represent only some embodiments of the present disclosure. Persons skilled in the art can derive other figures based on these figures without inventive effort.
FIG. 1 illustrates a schematic view of a back-contact solar cell;
FIG. 2A illustrates a schematic plan view of the back-contact solar cell (the back-contact solar cell is a busbar-free solar cell) according to an embodiment of the present disclosure;
FIG. 2B is a partial enlarged view of region A shown in FIG. 2A;
FIG. 3 is a simulation diagram showing a relationship between a conversion efficiency and D1 according to an embodiment of the present disclosure.
FIG. 4 is a cross-sectional view of the back-contact solar cell according to an embodiment of the present disclosure;
FIG. 5 is a schematic plan view of the back-contact solar cell according to an embodiment of the present disclosure (each busbar is connected to all solder pads in each solder pad group);
FIG. 6 is a schematic plan view of the back-contact solar cell according to an embodiment of the present disclosure (each busbar is connected to part of the solder pads in each solder pad group);
FIG. 7 is a schematic view showing the connection among an inner solder pad, and a homopolar finger, and between the inner pad and an heteropolar finger according to an embodiment of the present disclosure;
FIG. 8 illustrate another schematic plan view of a solder pad according to an embodiment of the present disclosure;
FIG. 9A is a schematic view of the back-contact PV module according to an embodiment of the present disclosure;
FIG. 9B is a partial enlarged view of region B in FIG. 9A;
FIG. 10 is a cross-sectional view illustrating the solder region of the solder pad and the solder strip according to an embodiment of the present disclosure;
FIG. 11 is a flow chart of the manufacturing method for the back-contact PV module according to an embodiment of the present disclosure;
FIG. 12 is another flow chart of the manufacturing method for the back-contact PV module according to an embodiment of the present disclosure;
FIG. 13 is a schematic diagram of an automatic string soldering device according to an embodiment of the present disclosure;
FIG. 14 is a schematic diagram of a rotatable carrier after adsorbing a solar cell according to an embodiment of the present disclosure;
FIG. 15 is a schematic plan view of the back-contact solar cell according to an embodiment of the present disclosure;
FIG. 16 is a schematic diagram of the target placement angle of the solar cell when the rotatable carrier is unfolded circumferentially according to an embodiment of the present disclosure;
FIG. 17 is a schematic diagram of a robotic arm while placing the solar cell according to an embodiment of the present disclosure;
FIG. 18 is a schematic diagram of a second included angle according to an embodiment of the present disclosure;
FIG. 19 is a schematic diagram of a conductive wire when being wound according to an embodiment of the present disclosure;
FIG. 20 is a schematic diagram of a curable adhesive when being applied according to an embodiment of the present disclosure;
FIG. 21 is a schematic diagram of the curable adhesive when being cured according to an embodiment of the present disclosure;
FIG. 22 is a schematic diagram of the distribution of curing adhesive strips according to an embodiment of the present disclosure;
FIG. 23 is a schematic diagram illustrating the conductive wire and the first gridline when being soldered according to an embodiment of the present disclosure;
FIG. 24 is a schematic plan view of another back-contact PV module according to an embodiment of the present disclosure;
FIG. 25 is a partial cross-sectional view of the back-contact PV module according to an embodiment of the present disclosure;
FIG. 26 is a partial cross-sectional view of an another back-contact PV module according to an embodiment of the present disclosure;
FIG. 27 is a schematic diagram of a second correction angle according to an embodiment of the present disclosure.

Description of the Reference Numerals:
1: back-contact solar cell; 101: first solar cell edge; 102: gridline-free region; 103: second solar cell edge; 11: back-contact solar cell body; 111: silicon substrate; 112: doped layer; M12: pad group; 12: pad; 12a: edge solder pad; 12b: inner solder pad; 13: finger; 13a: homopolar finger; 13b: heteropolar finger; 131: overlapping notch; 132: isolating notch; 14: busbar; 15: indented solder pad; 16: connecting gridline; 17: encapsulating adhesive layer; M1: cell string to be soldered;
X: first direction; Y: second direction;
D1: spacing between the edge solder pad and the nearest first solar cell edge; D2: length of the back-contact solar cell body in the first direction; D3: spacing between two adjacent solder pad groups; D4: spacing between the edge solder strip and the first solar cell edge; D5: spacing between the starting solder point and the nearest second solar cell edge; D6: first spacing; D7: second spacing; D8: third spacing; D9: fourth spacing; D10: fifth spacing; D11: sixth spacing; W1: width of the isolation notch; W2: width of the overlapping notch; W3: width of the solder strip; W4: preset maximum offset of the solder strip; T1: thickness of the first Sn-based alloy layer; T2: thickness of the second Sn-based alloy layer; θ₁: first included angle; θ₂: second included angle; Δθ₂: second correction angle;
2: solder strip; 2a: edge solder strip; 2b: center solder strip; 201: starting solder point; 21: Ag-Sn alloy layer; 22: first Sn-Pb alloy layer; 23: conductive metal-Sn alloy layer; 24: conductive metal layer; 25, second Sn-Pb alloy layer;
3: rotatable carrier; 31: robotic arm; 4: guide mechanism; 5: adhesive application apparatus; 51: curing adhesive strip; 6: curing light box; 7: infrared light box.

### DETAILED DESCRIPTION OF THE EMBODIMENTS

The technical solutions in the embodiments of the present disclosure will be clearly and completely described below in conjunction with the drawings in the embodiments of the present disclosure. Obviously, the described embodiments are only part of the embodiments of the present disclosure, rather than all the embodiments. Based on the embodiments of the present disclosure, all other embodiments obtained by a person of ordinary skill in the art without creative efforts fall within the protection scope of the present disclosure.

In the present disclosure, terms such as "upper," "inner," "outer," "lateral," and "longitudinal" indicate orientations or positional relationships based on the orientations or positional relationships shown in the accompanying drawings. These terms are primarily intended to better describe the present disclosure and its embodiments and are not intended to limit the devices, elements, or components indicated to specific orientations, or to their construction and operation.

Further, some of these terms may be used to indicate more than orientations or positional relationships. For example, the term "upper" may also be used in certain circumstances to indicate a dependency or connection. Those skilled in the art will understand the specific meanings of these terms in the present disclosure based on the specific circumstances.

In addition, the terms "disposed," "connected," and "connected to each other" should be interpreted broadly. For example, they can refer to fixed connections, removable connections, or integral configurations; mechanical connections or electrical connections; direct connections, indirect connections through an intermediate medium, or internal connections between two devices, elements, or components. Those skilled in the art will understand the specific meanings of these terms in the present disclosure based on the specific circumstances.

In addition, the terms "first," "second," etc. are primarily used to distinguish between different devices, elements, or components (the specific types and configurations may be the same or different) and are not intended to indicate or imply the relative importance or quantity of the devices, elements, or components indicated. Unless otherwise specified, "plurality" means two or more.

In actual research work, the inventors have discovered that stress concentration occurs at edge regions of back-contact solar cells, making the back-contact solar cells more susceptible to cracking under external forces. During the soldering process, pressing pins press solder strip onto the solder pads, and the solder pads bear the concentrated load. If the solder pads are placed at edges of the solar cell, stress concentration can further amplify the effects of external forces, potentially leading to cracking occurred at edge regions. To avoid this type of poor soldering at edges, the edge solder pads are typically placed farther from the solar cell edge, for example, with a spacing of at least 2 mm between the edge solder pad and the closest solar cell edge.

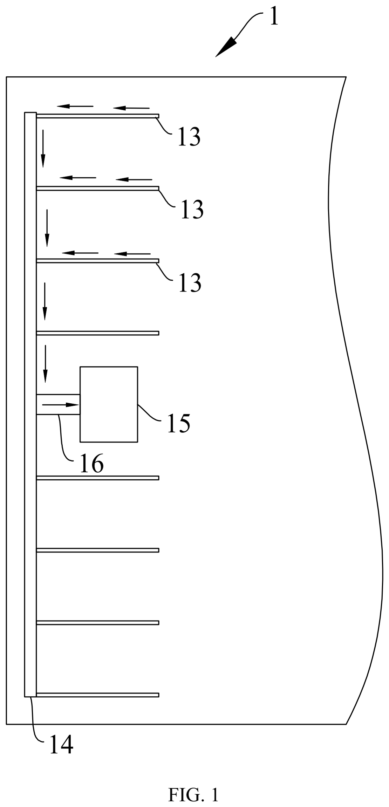

FIG. 1 illustrates a schematic view of a back-contact solar cell. Due to a large spacing between the edge solder pad and the solar cell edge, a finger 13 and a busbar 14 are required between the edge solder pad and the solar cell edge to sufficiently collect the current from a back surface of the cell. The busbar 14, disposed outside the edge solder pad, is not involved in the soldering processing. Therefore, the current from the finger 13 must be collected by the busbar 14 and then can be transported to the edge solder pad via the connecting gridline 16. The current transportation pathway can refer to FIG. 1, where an arrow (→) indicates a current transportation pathway of the finger 13. The edge solder pad acts as an indentation of the connected fingers 13 and busbars 14, known in the related art as an indented pad 15.

It should be understood that, this portion of the finger 13 does not form a direct electrical connection with the indented pad 15, but rather an indirect electrical connection, which results in a long current transportation pathway and a high current transportation loss in this portion of the finger 13.

Based on the above analysis, embodiments of the present disclosure provides a back-contact solar cell, a spacing between the edge solder pad and the closest first solar cell edge sufficiently small, such that the finger connected to the edge solder pad is sufficiently close to the first solar cell edge, which is conducive to expanding a carrier collection region of the finger, and conducive to shortening a transportation spacing for the charge carriers close to the first solar cell edge to reach the edge solder pad. The shorter the transportation spacing, the smaller the series resistance loss of the charge carriers caused by the resistance in the back-contact solar cell body, leading to higher conversion efficiency in the back-contact solar cell. Further, since the current collection region of the finger is already sufficiently close to the first solar cell edge, the finger no longer needs to extend outside the edge solder pad for current collection and can form a direct electrical connection with the edge solder pad. Further, compared to the conventional edge design with the connecting gridline 16 and the indented pad 15, the present disclosure shortens the charge carrier transportation pathway, further reducing the transportation loss of the charge carriers and addressing the issue of the EL (electroluminescence) blackening occurred at edges of the back-contact solar cell.

The technical solution of the present disclosure will be described below with reference to embodiments and accompanying figures.

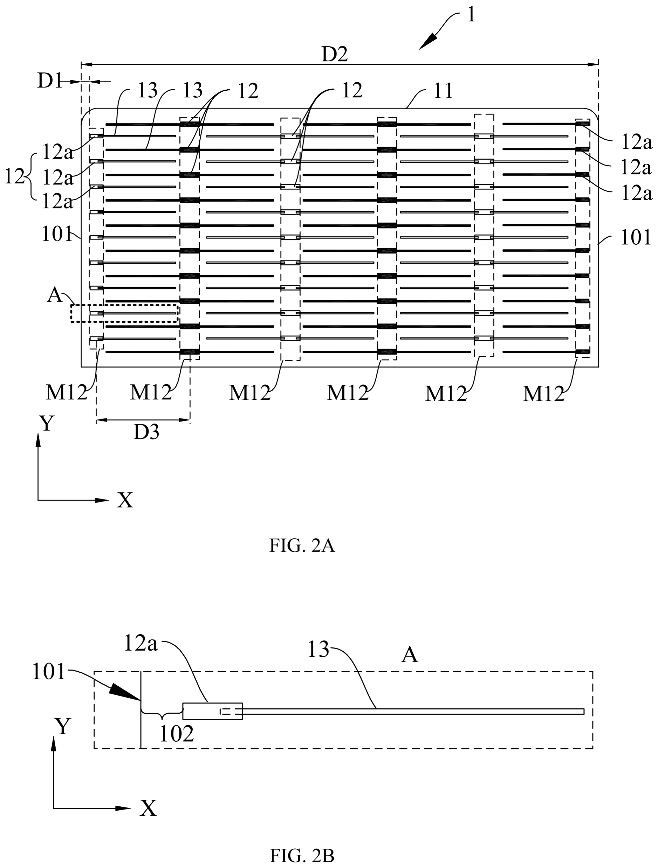

FIG. 2A illustrates a schematic plan view of the back-contact solar cell according to an embodiment of the present disclosure. For achieving a better understanding, a first direction X is a horizontal direction in FIG. 2A, which also corresponds to a length direction of the finger 13, and a second direction Y is a longitudinal direction in FIG. 2A. The second direction Y is not necessarily perpendicular to the first direction X; it can also intersect with the first direction X in an approximately perpendicular way, for example, at an angle of 80°, 85°, 87°, or 89°.

Referring to FIG. 2A, this embodiment of the present disclosure discloses a back-contact solar cell 1 including a back-contact solar cell body 11, a plurality of solder pad groups M12 of two polarities, and a plurality of fingers 13 of two polarities.

The plurality of solder pad groups M12 of two polarities are arranged alternately and spaced apart on a back surface of the back-contact solar cell body 11 along the first direction X. Each solder pad group M12 includes a plurality of solder pads 12 of the same polarity arranged along the second direction Y.

The plurality of fingers 13 of two polarities are arranged on the back surface of the back-contact solar cell body 11, and each solder pad 12 is connected to at least one finger 13 of the same polarity and spaced apart from the fingers 13 of opposite polarity.

Along the first direction X, the back-contact solar cell body 11 has two first solar cell edges 101 arranged opposite to each other. A solder pad in the plurality of solder pad groups M12 closest to each first solar cell edge 101 is defined as an edge solder pad 12a. A spacing between edge solder pad 12a and the closest first solar cell edge 101 is D1. A length of the back-contact solar cell body 11 in the first direction X is D2, and 0.043% < D1/D2 < 0.870%.

The following describes the beneficial effects of the back-contact solar cell 1 of the present disclosure.

In the back-contact solar cell 1 of the present disclosure, the plurality of solder pad groups M12 of two polarities are arranged alternately and spaced apart on the back surface of the back-contact solar cell body 11 along the first direction X. In other words, the plurality of pad groups M12 of positive polarity and solder pad groups M12 having negative polarity are arranged alternately and spaced apart along the first direction X. Each solder pad group M12 includes a plurality of pads 12 of the same polarity spaced apart along the second direction Y. Each solder pad 12 is connected to at least one finger 13 of the same polarity as the solder pad 12 and is spaced apart from fingers 13 of opposite polarity with the solder pad 12. As such, the solder pad 12 and the finger 13 connected to the solder pad 12 are relatively evenly and densely distributed on the back surface of the back-contact solar cell body 11 in both the first direction X and the second direction Y, which facilitates better carrier collection and carrier transportation within back-contact solar cell body 11, reducing resistance loss of carriers caused by the transportation in the back-contact solar cell body 11.

Accordingly, the spacing between edge solder pad 12a and the closest first solar cell edge 101 is D1, and the length of the back-contact solar cell body 11 in the first direction X is D2, and 0.043% < D1/D2 < 0.870%. D1/D2 can be, for example, 0.044%, 0.1%, 0.2%, 0.3%, 0.4%, 0.5%, 0.6%, 0.7%, 0.8%, or 0.869%.

When D1/D2 meets the aforementioned ratio range, the spacing between the edge solder pad 12a and the closest first solar cell edge 101 is sufficiently small, allowing the finger 13 being connected to the edge solder pad 12a to be sufficiently close to the first solar cell edge 101, which helps to expand the carrier collection region of the finger 13 and shorten the transportation pathway for photogenerated carriers close to the first solar cell edge 101 to reach the edge solder pad 12a. The shorter the transportation pathway, the smaller the series resistance loss of the charge carriers caused by the resistance in the back-contact solar cell body 11, and the higher the conversion efficiency of the back-contact solar cell 1.

Further, the spacing between the edge solder pad 12a and the closest first solar cell edge 101 is not too small, such that there is sufficient printing engineering margin for the edge solder pad 12a, so as to reduce the risk of printing the paste outside the back-contact solar cell body 11.

As such, the back-contact solar cell 1 achieves both high conversion efficiency and reduced risk of printing abnormalities with the edge solder pad 12a.

The following describes the spacing between the edge solder pad and the closest first solar cell edge D1 in detail.

It should be noted that since the back-contact solar cell body 11 of the present disclosure has two first solar cell edges 101 arranged opposite to each other, for each edge solder pad 12a, the closest first solar cell edge 101 refers to the first solar cell edge 101 in the two first solar cell edges 101 closest to the edge solder pad 12a.

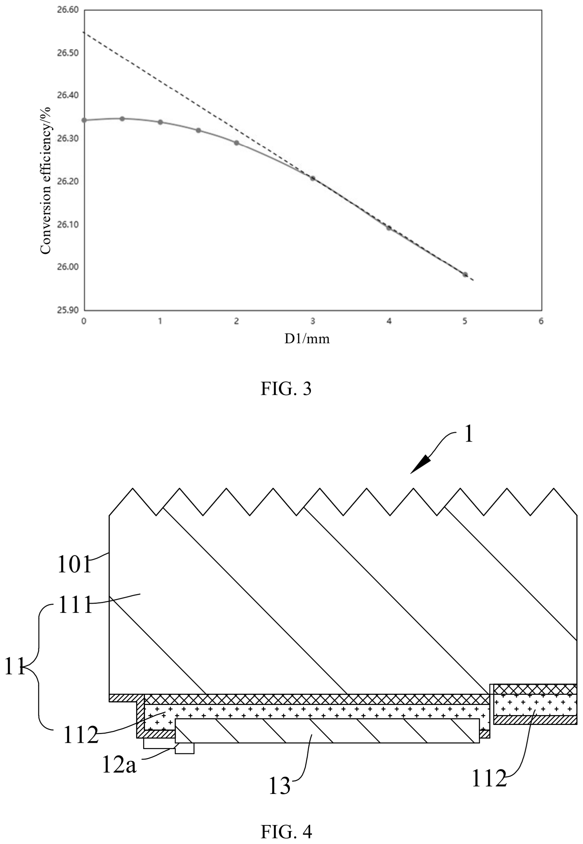

Referring to FIG. 2A and FIG. 3, for examples, 0.1 mm < D1 < 2 mm. D1 can be, for example, 0.1 mm, 0.3 mm, 0.5 mm, 0.7 mm, 0.9 mm, 1.1 mm, 1.3 mm, 1.5 mm, 1.7 mm, 1.9 mm, or 1.99 mm.

It should be noted that for the industrial-grade back-contact solar cell 1 with a dimension of 166 mm, 182 mm, or 210 mm along the first direction X, when D1< 2 mm, a spacing between the edge solder pad 12a and the closest first solar cell edge 101 is sufficiently small, allowing the finger 13 connected to the edge solder pad 12a to be sufficiently close to the first solar cell edge 101. This helps expand the carrier collection region of the finger 13 and shorten the transportation pathway for photogenerated carriers generated close to the first solar cell edge 101 to reach the edge solder pad 12a. The shorter the transportation pathway, the smaller the series resistance loss of the charge carriers caused by the resistance in the back-contact solar cell body 11, which helps to improve the conversion efficiency of the back-contact solar cell 1.

Further, when D1 > 0.1 mm, the edge solder pad 12a is not too close to the first solar cell edge 101, thus there is sufficient printing engineering margin for the edge solder pad 12a, so as to reduce the risk of the paste of the edge solder pad 12a being printed outside the back-contact solar cell body 11. Further, when D1 > 0.1 mm, sufficient margin for placement accuracy is provided for the solder strip 2 on the edge solder pad 12a, thus preventing the solder strip 2 from shifting outside the back-contact solar cell 1. This, in turn, prevents the solder strip 2 from contacting other back-contact solar cells 1 or metal components, which could cause leakage. This improves the soldering yield of the back-contact PV module.

Further, 0.1 mm < D1 < 1 mm. When D1 falls within the aforementioned spacing range, the current collection range of the finger 13 on the edge solder pad 12a is further expanded, so as to fully utilize a region of the back-contact solar cell body 11 within a width of 1 mm from the first solar cell edge 101, further improving the conversion efficiency of the back-contact solar cell 1. FIG. 3 shows a simulation diagram of the conversion efficiency versus D1 (the spacing between the edge solder pad 12a and the closest first solar cell edge 101) of the back-contact solar cell according to an embodiment of the present disclosure. It can be seen that when D1 < 1 mm, the conversion efficiency of the back-contact solar cell is not significantly improved while D1 changing, indicating that the back-contact solar cell is approaching the optimum conversion efficiency.

The edge solder pad and the finger will be further described in detail in the present disclosure.

In some embodiments, referring to FIG. 2A and FIG. 2B, a direct electrical connection is formed between an edge solder pad 12a and a finger 13.

In the present disclosure, the term "direct electrical connection" means that there is no intervening electrode between the edge solder pad 12a and the finger 13, thereby improving the current transportation efficiency and reducing current transportation losses, and improving the conversion efficiency of the back-contact solar cell 1 and reducing the problem of EL blackening at edges of the back-contact solar cell 1.

More specifically, direct electrical connection can be achieved through, for example, overlapping or abutting. Overlapping means a portion region of the finger 13 and a portion region of the edge solder pad 12a are overlapped, allowing them to be in a direct contact and form a direct electrical connection. Abutting means a partial region of the finger 13 and a partial region of the edge solder pad 12a are attached together, allowing them to be in direct contact and form a direct electrical connection.

In some embodiments, referring to FIG. 2A and FIG. 2B, along the first direction X, only an end of the edge solder pad 12a away from the closest first solar cell edge 101 is connected to the finger 13. The connection method is, for example, a direct electrical connection.

In addition, on the back surface of the back-contact solar cell body 11, a region between the edge solder pad 12a and the closest first solar cell edge 101 is a gridline-free region 102.

For a better understanding, an end of the edge solder pad 12a away from the closest first solar cell edge 101 is referred to as an inner end of the edge solder pad 12a. Correspondingly, another end of the edge solder pad 12a along the first direction X is referred to as an outer end of the edge solder pad 12a.

When the edge solder pad 12a of the present disclosure is sufficiently close to the first solar cell edge 101, the finger 13 connected to the inner end of the edge solder pad 12a can also be sufficiently close to the first solar cell edge 101, thereby fully collecting the current from the back surface of the back-contact solar cell body 11. It should be noted that in the present disclosure, current is a macroscopic representation of the directional movement of the charge carriers.

Thus, even without the gridline provided on the outer end of the edge solder pad 12a, the back-contact solar cell 1 of the present disclosure can still fully collect the current from the back surface of the back-contact solar cell body 11, thus enabling the region between the edge solder pad 12a and the closest first solar cell edge 101 to be the gridline-free region 102.

In the present disclosure, the term "gridline-free region 102" refers to a region without printed gridlines, such as fingers, busbars, interconnecting gridlines, or connecting gridlines, which serves to transport current.

The back-contact solar cell 1 of the present disclosure utilizes the gridline-free region 102 to reduce the risk of gridlines being printed outside the back-contact solar cell body 11. Further, the gridline-free region 102 helps to reduce the edge leakage and the carrier recombination, as discussed below.

The back-contact solar cell body 11 of the present disclosure is now described.

In some embodiments, referring to FIG. 4, the back-contact solar cell body 11 includes a silicon substrate 111 and two doped layers 112 of different doping types.

The two doped layers 112 of different doping types are spaced apart and arranged on the back surface of the silicon substrate 111. Fingers 13 of different polarities form ohmic contacts with the doped layers 112 of corresponding doping types.

Since the region between the edge solder pad 12a and the closest first solar cell edge 101 is not provided with the gridline, the doped layer around the first solar cell edge 101 can be removed, so as to reduce the edge leakage and the carrier recombination caused by the doped layer.

In the present disclosure, the back-contact solar cell 1 may be provided with busbars or without busbars, which can be described in detail below.

In some embodiments, referring back to FIG. 2A, the back-contact solar cell 1 is a solar cell without busbars, which is also known as a busbar-free solar cell. The busbar-free solar cell do not require printing the busbar 14, which reduces the amount of printed silver paste and improves the contacting characteristics of the metal electrodes, thereby increasing the fill factor and conversion efficiency of the back-contact solar cell.

Further, when the back-contact solar cell 1 is the busbar-free solar cell, a total orthographic projection area of the solder pad 12 on the back-contact solar cell body 11 is S1, and an area of the back surface of the back-contact solar cell body 11 is S2, and 0.05% ≤ S1/S2 ≤ 6.2%.

It should be understood that in the busbar-free solar cell, only the solder pad 12 is involved in soldering, and the total orthographic projection area S1 of the solder pad 12 on the back-contact solar cell body 11 is equal to the soldering area. As analyzed above, S1/S2 is the soldering area ratio. When 0.05% ≤ S1/S2 ≤ 6.2%, the warpage degree of the back-contact solar cell 1 due to the mismatch in thermal expansion coefficients of the materials involved in soldering can be controlled within a small range, for example, 4 mm. Considering the high hardness of the silicon substrate, when the warpage degree of the solar cell is greater than 4 mm due to soldering, hidden cracks may be occurred in the solar cell during module packaging. Therefore, controlling the warpage degree of the back-contact solar cell 1 within a small range can improve the packaging yield of the back-contact PV module.

It should be noted that the warpage degree of the solar cell refers to the maximum height of the back-contact solar cell 1 after being soldered, taking the plane on which the back contact solar cell 1 is placed as a reference plane.

In an embodiment, the number of the solder pad groups M12 is greater than or equal to 30 and less than or equal to 120, for example, the number of the solder pad groups M12 can be 30, 40, 50, 60, 70, 80, 100, or 120. When the solder pad groups M12 with a number in the aforementioned range are distributed on the back surface of the back-contact solar cell 1, the spacing between solder pad groups M12 is narrower. Current collected by the finger 13 can be transported to the solder pad groups M12 over a shorter spacing, and the current is then collected by the solder strip. This reduces ohmic losses in the finger 13 during current transportation, thereby improving the conversion efficiency of the back-contact solar cell 1.

Further, considering that the warpage degree of the back-contact solar cell 1 is directly proportional to the number of the solder pad groups M12, the solder pad groups M12 of the number in this range can control the warpage degree of the solar cell of the back-contact solar cell 1 within a relatively small range, for example, less than 4 mm. This reduces the packaging abnormalities of the back-contact solar cell 1 caused by large warpage degree of the solar cell, thereby improving the packaging yield and reliability of the back-contact PV module.

In embodiments, the spacing between two adjacent solder pad groups M12 is D3, and 1.5 mm ≤ D3 ≤ 8 mm. D3 can be, for example, 1.5 mm, 2 mm, 4 mm, 6 mm, 7 mm, or 8 mm. When the spacing D3 between two adjacent solder pad groups M12 falls within the aforementioned range, the current collected by the finger 13 can be transported to the solder pad group M12 over a shorter spacing, reducing ohmic losses caused by current transportation within the finger 13.

It should be noted that the spacing between two adjacent solder pad groups M12 refers to the spacing between the centers of the two adjacent solder pad groups M12 along the first direction X.

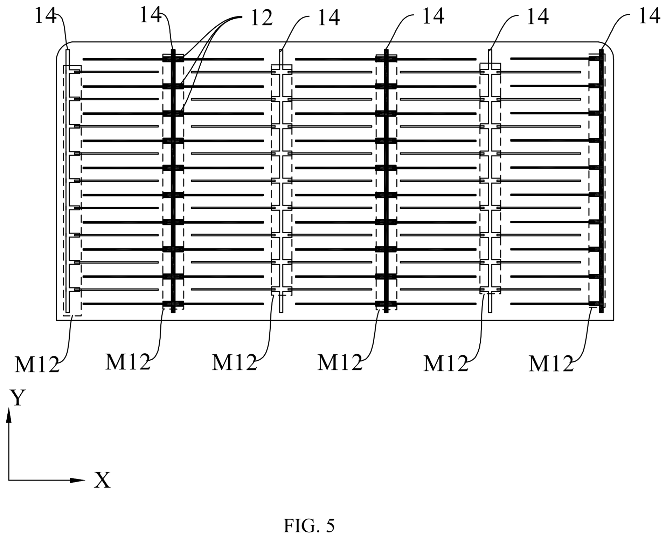

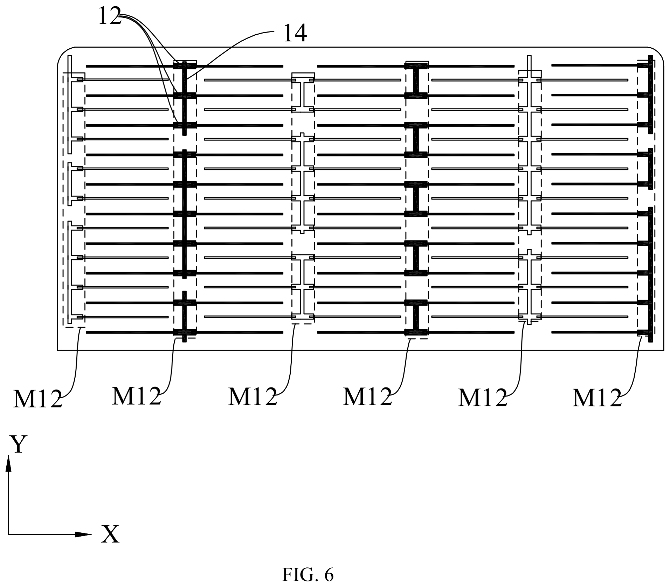

In some embodiments, referring to FIG. 5 and FIG. 6, the back-contact solar cell 1 further includes a plurality of busbars 14, and each busbar 14 extends along the second direction Y. In the present disclosure, the busbars 14 can also be soldered to the solder strips 2, thereby increasing the solder area of the solder strip 2, improving the pull-off strength of the solder strip 2, and enhancing the soldering reliability. In the present disclosure, the busbars 14 and the solder pad group M12 can be connected in various ways, as detailed below.

In one embodiment, referring to FIG. 5, each busbar 14 is connected to all pads 12 in each solder pad group M12. In this embodiment, all pads 12 in each solder pad group M12 are interconnected via the busbar 14. Even if part of solder pads 12 become disconnected from the solder strip 2, the current on these solder pads 12 can still be collected by the busbar 14 and transported to other pads 12 in the same pad group M1, thus preventing current collection failure.

In another embodiment, referring to FIG. 6, each busbar 14 is connected to a part of the solder pads 12 in each solder pad group M12. For example, each busbar 14 is connected to one, two, three, or four pads 12 in each solder pad group M12. Each solder pad group M12 may be connected to one or more busbars 14.

As such, the solder pad group M12 can enlarge its soldering area via the busbars 14. When the plurality of solder pads 12 are connected via the busbars 14, the plurality of solder pads 12 can also be interconnected via the busbars 14, thereby preventing the failure to collect current from a finger connected to a single solder pad due to poor soldering of the single solder pad. Compared to the previous embodiment, a total area of the busbars 14 in this embodiment may be reduced, thereby reducing silver paste usage and improving the double-sided rate of the back-contact solar cell.

Further, when the back-contact solar cell 1 includes busbars 14, a total orthographic projection area of the busbars 14 and the solder pads 12 on the back-contact solar cell body 11 is S1, and an area of the back surface of the back-contact solar cell body 11 is S2, and 0.05% ≤ S1/S2 ≤ 6.2%.

As described above, both the busbars 14 and the solder pads 12 are included in soldering processing. The total orthographic projection area S1 of the busbars 14 and the solder pads 12 on the back-contact solar cell body 11 is equal to the soldering area. In the present disclosure, a ratio S1/S2 of the back surface of back-contact solar cell body 11 represents the soldering area ratio. The inventors have discovered that the warpage degree of the back-contact solar cell 1 is directly proportional to the solder area ratio. When S1/S2 ≤ 6.2%, the warpage degree of the back-contact solar cell 1 can be controlled within a relatively small range, for example, the warpage degree of the back-contact solar cell 1 can be controlled within 4 mm. Considering the high hardness of the silicon substrate, the warpage degree of the solar cell greater than 4mm due to soldering can cause hidden cracks in the solar cell during module packaging. Therefore, controlling the warpage degree of the back-contact solar cell 1 within a small range can improve the packaging yield of the back-contact PV module.

Further, 0.05% ≤ S1/S2 indicates that the back-contact solar cell 1 has a sufficiently large soldering area. This means that the solder strip 2 and the back-contact solar cell 1 can form a more complete contact, which helps reduce contact resistance and increase soldering pull-off force, thereby improving the output power and reliability of the back-contact PV module using the back-contact solar cell 1.

The following describes the inner solder pad 12b and the finger 13 of the present disclosure.

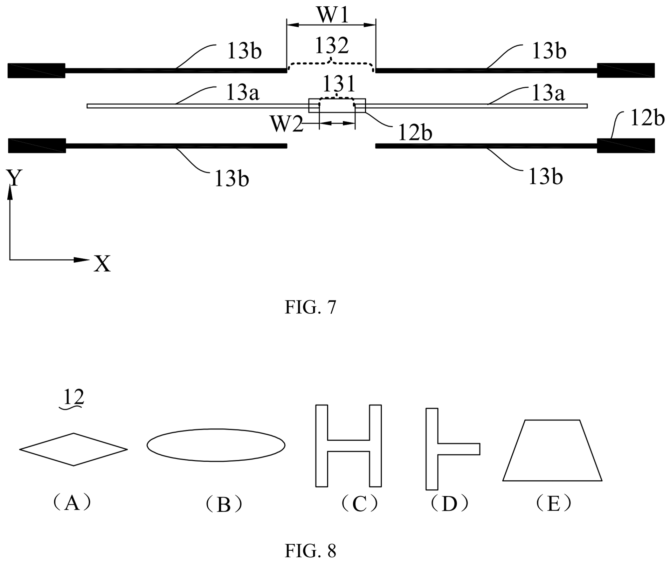

In some embodiments, referring to both FIG. 2A and FIG. 7, each finger 13 extends along the first direction X, and the plurality of fingers 13 of two polarities are arranged alternately in a column along the second direction Y. In the present disclosure, the first direction X can be perpendicular to the second direction Y. For example, the first direction X is the length direction of the back-contact solar cell body 11, and the second direction Y is the width direction of the back-contact solar cell body 11. In this manner, the fingers 13 of two polarities are distributed on the back surface of the back-contact solar cell body 11 along both the first direction X and the second direction Y, thus facilitating efficient current collection on the back surface of the back-contact solar cell body 11.

Based on the above, a plurality of columns of the fingers 13 are spaced apart along the first direction X, and a discontinuity region is formed between two adjacent columns of fingers 13. Except for the edge solder pads 12a, the remaining solder pad groups M12 are located in each discontinuity region, and the solder pads 12 included in the remaining solder pad groups M12 are defined as inner solder pads 12b.

On either side of each discontinuity region, the fingers 13 having the same polarity as the inner pad 12b are referred to as homopolar fingers 13a. Along the first direction X, overlapping notches 131 are formed between two adjacent homopolar fingers 13a. Each inner pad 12b is provided in a corresponding overlapping notch 131, and both ends of the inner pad 12b are overlapped with the two homopolar fingers 13a.

More specifically, when the inner solder pads 12b are solder pads 12 of positive polarity, the aforementioned homopolar fingers 13a refer to the fingers 13 of positive polarity. Conversely, when inner pad 12b is the pads 12 of negative polarity, the homopolar fingers 13a refer to fingers 13 of negative polarity.

It should be understood that the two homopolar fingers 13a form a direct electrical connection with the same inner solder pad 12b through overlapping, thereby improving current transportation efficiency, reducing current transportation losses, and thereby enhancing the conversion efficiency of the back-contact solar cell 1.

Since when the homopolar fingers 13a and the inner solder pads 12b are overlapped, the two are overlapped with each other, a height of the overlapping region is higher than a height of the remaining inner solder pad 12b, thus forming a height difference. Therefore, in this embodiment of the present disclosure, the solder strip 2 can be placed within the overlapping notch 131, thereby offsetting the overlapping region. In this way, the solder strip 2 is in contact with a region of the solder pad 12 with a relatively consistent height and is offset from the regions of the solder pad 12 with height differences, enabling better attachment and better soldering of the solder strip 2 being soldered to the solder pad 12.

Further, on both sides of each discontinuity region, the fingers 13 having the opposite polarity with the inner solder pads 12b are defined as heteropolar fingers 13b. Along the first direction X, an isolating notch 132 is formed between the two heteropolar fingers 13b.

Along the first direction X, a width W1 of the isolating notch 132 is greater than a width W2 of the overlapping notch 131. Therefore, the solder strip 2 soldered to the inner solder pad 12b is kept as far away from the heteropolar finger 13b as possible to prevent short circuiting.

It should be understood that when the inner solder pads 12b is the solder pads 12 of positive polarity, the heteropolar fingers 13b refers to the fingers 13 of negative polarity. Conversely, when the inner solder pad 12b is the solder pads 12 of negative polarity, the heteropolar fingers 13b refer to the fingers 13 of positive polarity.

In embodiments, 0.15 mm ≤ W2 ≤ 0.7 mm. The width W2 of the overlapping notch 131 is, for example, 0.15 mm, 0.2 mm, 0.3 mm, 0.5 mm, or 0.7 mm. Since a projected width of the solder strip 2 on the solar cell ranges from 0.15 mm to 0.25 mm, and a maximum preset offset of the solder strip 2 is less than 0.1 mm, the overlapping notches 131 within this width range can accommodate solder strips 2 within this width range and provide an engineering margin for the placement offset of the solder strip 2, allowing the solder pad 12 to fit neatly within the overlapping notches 131. This prevents the solder strip 2 from contacting the homopolar fingers 13a and causing Ag corrosion reaction, which results in finger breakage.

In the present disclosure, Ag corrosion reaction refers to the reaction between the Sn-based alloy on the solder strip 2 and the Ag in the gridlines. This reaction causes silver loss and affects the conductive properties of the fingers. This is especially true when the Sn-based alloy completely reacts with the metal material (e.g., Ag) on the solder pad, leaving the solder region devoid of metal. This can lead to finger breakage or poor soldering at the solder region, such that the solder region is unable to provide an effective transportation medium for charge carriers.

Further, the solder strip 2 can be staggered with the overlapping region on the solder pads 12, thus ensuring better attachment and soldering performance.

Further, since a length of pad 12 along the first direction X requires to be greater than a width W2 of the overlapping notch 131 to simultaneously overlap with two homopolar fingers 13a, the overlapping notch 131 within this width range prevents the solder pad 12 from being excessively long, thereby reducing the light-shading region of the solder pad 12 and the amount of silver paste used in paste-printing.

In an embodiment, 0.3 mm ≤ W1 ≤ 1.2 mm. W1 is, for example, 0.3 mm, 0.6 mm, 0.9 mm, or 1.2 mm. When the width W1 of the isolating notch 132 falls within this range, the heteropolar fingers 13b can avoid to contact solder strips 2 within this range and provide sufficient engineering offset margin for placement of the solder strip 2, thereby preventing short circuiting. As such, the heteropolar fingers 13b can achieve insulation isolation from the solder strip 2 even without applying insulating adhesive. Further, the isolating notches 132 within the aforementioned width range should be kept not too wide to prevent the heteropolar fingers 13b from being too short and thus affecting the collection efficiency of the charge carriers.

For example, as shown in FIG. 7, the solder pad is shaped as a square. The square pad has a uniform width throughout, allowing for a good soldering to the square pad even when the solder strip is offset.

For another example, as shown in FIG. 8 (A), the solder pad 12 is shaped as a diamond. As shown in FIG. 8 (B), the solder pad 12 is shaped as an ellipse. As shown in FIG. 8 (C), the solder pad 12 is H-shaped. As shown in FIG. 8 (D), the solder pad 12 is T-shaped. As shown in FIG. 8 (E), the solder pad 12 is shaped as a trapezoid.

The solder pad 12 having the shape of the diamond or the ellipse is wide in the middle and narrow at both ends. The solder pads having these shapes can utilize their wider middle portion to be soldered to the solder strip 2, resulting in a good soldering effect. Further, the two narrower ends of the solder pad 12 having the shape of the diamond or the ellipse reduce the amount of silver paste used during printing. The solder pad 12 has the shape of the H is wider at both ends, and can provide sufficient offset engineering margin for printing the homopolar fingers 13a.

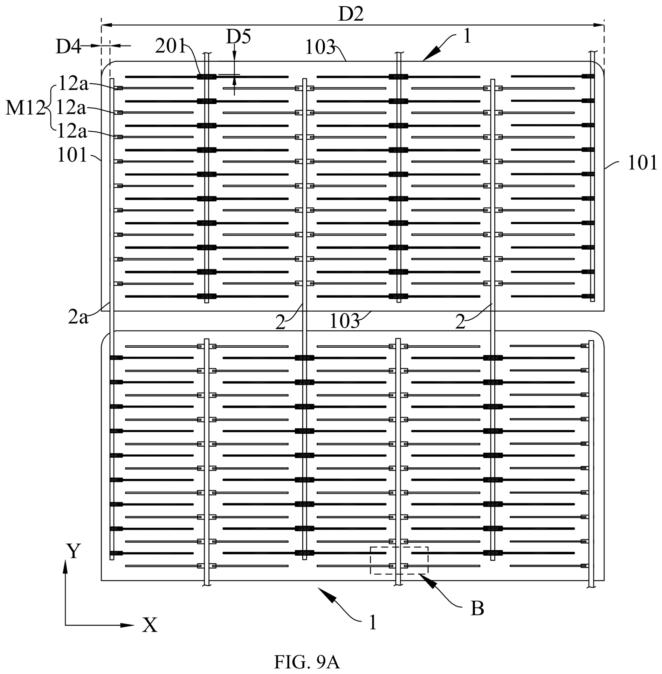

Referring to FIG. 9A, an embodiment of the present disclosure discloses a back-contact PV module, including a plurality of back-contact solar cells electrically connected and a plurality of solder strips 2. At least one back-contact solar cell is the back-contact solar cell 1 according to any aforementioned embodiment of the present disclosure.

Each solder strip 2 is soldered to each solder pad group M12, and the solder strip 2 soldered to the edge solder pad 12a is defined as an edge solder strip 2a. A spacing between the edge solder strip 2a and the closest first solar cell edge 101 is D4, and 0.043% < D4/D2 < 0.870%.

The following describes the beneficial effects of the back-contact PV module of the present disclosure.

D4/D2 is, for example, 0.044%, 0.1%, 0.2%, 0.3%, 0.4%, 0.5%, 0.6%, 0.7%, 0.8%, or 0.869%. When D4/D2 meets the aforementioned ratio range, the spacing between the edge solder strip 2a and the first solar cell edge 101 is sufficiently small, allowing current on the edge solder pad 12a to be transported to the edge solder strip 2a via a shorter transportation pathway. The shorter the transportation pathway, the less the series resistance loss between the edge solder pad 12a and the edge solder strip 2a due to the inherent resistance of the transportation medium, thereby increasing the power density of the back-contact PV module.

Further, the spacing between the edge solder strip 2a and the closest first solar cell edge 101 is not too small, and there is sufficient engineering margin for placement of the edge solder strip 2a to prevent the edge solder strip 2a from being placed outside of the back-contact solar cell 1 and thus being able to collect current. This ensures a higher power density for the back-contact PV module and reduces the risk of leakage from the edge solder strip 2a.

The following describes a spacing D4 between the edge solder strip 2a and the first solar cell edge 101 in the present disclosure in detail.

In an embodiment, 0.1 mm ≤ D4 < 2 mm. D4 is, for example, 0.11 mm, 0.3 mm, 0.5 mm, 0.7 mm, 0.9 mm, 1.1 mm, 1.3 mm, 1.5 mm, 1.7 mm, 1.9 mm, or 1.99 mm. For the industrial-standard back-contact solar cell 1 with a dimension of 166 mm, 182 mm, or 210 mm along the first direction X, when D4<2 mm, the spacing between the edge solder strip 2a and the closest first solar cell edge 101 is sufficiently small, allowing current from the edge solder pad 12a to be transported to the edge solder strip 2a via a shorter transportation pathway. The shorter the transportation pathway, the less the series resistance loss between the edge solder pad 12a and the edge solder strip 2a due to the inherent resistance of the transportation medium, thereby increasing the power density of the back-contact PV module.

Further, when 0.1 mm<D4, the spacing between the edge solder strip 2a and the closest first solar cell edge 101 is not too small, and there is sufficient engineering margin for placement of the edge solder strip 2a to prevent the edge solder strip 2a from being placed outside the back-contact solar cell 1 and thus preventing the situation occurred where the current could not be collected.

Further, 0.1 mm < D4 < 1 mm. When D4 < 1 mm, the current collection range of the finger 13 on the edge solder pad 12a is further expanded, fully utilizing a region of the back-contact solar cell body 11 within a 1 mm width from the first solar cell edge 101, further improving the conversion efficiency of the back-contact solar cell 1. At the same time, the current on the edge solder pad 12a can be transported to the edge solder strip 2a via a shorter transportation pathway, thereby increasing the power density of the back-contact PV module.

The following describes the starting solder point 201 of the solder strip 2 of the present disclosure in detail.

In some embodiments, the back-contact solar cell body 11 has two second solar cell edges 103 opposite to each other along the second direction Y, and the solder position of the solder strip 2 closest to the second solar cell edge 103 is defined as the starting solder point 201.

It should be noted that the starting solder point 201 is often located on the solder pad closest to the second solar cell edge 103 in the solder pad group.

The spacing between the starting solder point 201 and the closest second solar cell edge 103 is D5, and 0.5 mm ≤ D5 ≤ 5 mm.

When the spacing D5 between the starting solder point 201 and the closest second solar cell edge 103 falls within the aforementioned range, the current transportation pathway, configured to collect the current from the finger 13 close to the second solar cell edge 103 to the starting solder point 201, is shorter, which helps reduce series resistance loss caused by current transportation pathway. Further, since the second solar cell edge 103 is a poor position of the back-contact solar cell 1, when the spacing D5 between the starting solder point 201 and the closest second solar cell edge 103 falls within the aforementioned range, the back-contact solar cell 1 can be prevented from being damaged resulted from the mechanical pressure occurred during the soldering processing of the solder strip 2.

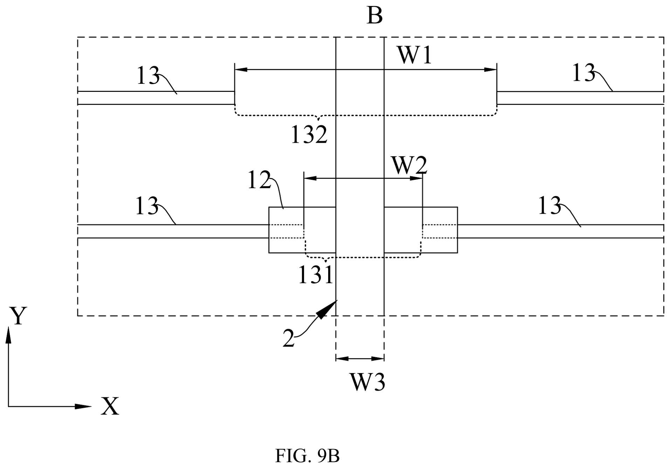

Referring to FIG. 9A and FIG. 9B, an embodiment of the present disclosure discloses a back-contact PV module, including a plurality of electrically connected back-contact solar cells and solder strips 2. At least one back-contact solar cell is the back-contact solar cell 1 according to any aforementioned embodiment of the present disclosure. Each solder strip 2 is soldered to each solder pad group M12.

Along the first direction X, each solder pad group M12 is spaced apart from an adjacent finger 13 of opposite polarity without insulating adhesive being provided therebetween.

The following describes the beneficial effects of the back-contact PV module of the present disclosure.

The present disclosure achieves insulation isolation by spacing each solder pad group M12 from the adjacent finger 13 of opposite polarity, which is not necessary to provide insulating adhesive between the pad group M12 and the fingers 13, thus reducing material costs and simplifying processing steps.

Further, contraction stress during the curing process of the insulating adhesive is a key cause of warpage in the back-contact solar cell 1. Thus, by omitting the insulating adhesive, the back-contact solar cell 1 in the present disclosure avoids contraction stress on the back surface of the back-contact solar cell 1, thereby reducing the warpage degree of the back-contact solar cell1 and, consequently, reducing soldering defects caused by the excessive warpage degree of the back-contact solar cell1.

In an embodiment, along the first direction X, the width of the isolating notch 132 is W1, and a width of the solder strip 2 is W3, and W1>W3.

Since the width W1 of the isolating notch 132 is greater than the width W3 of the solder strip 2, the isolating notch 132 provides sufficient engineering margin for offsetting the solder strip 2 during placement. The width W1 of the isolating notch 132 may be adjusted based on the offset of the solder strip. This ensures that even if the solder strip 2 is offset during placement, the solder strip 2 can still maintain a space from the heteropolar fingers 13b on both side of the isolating notch 132, thereby achieving insulation isolation, and there is no need for providing insulating adhesive for insulation in the back-contact PV module.

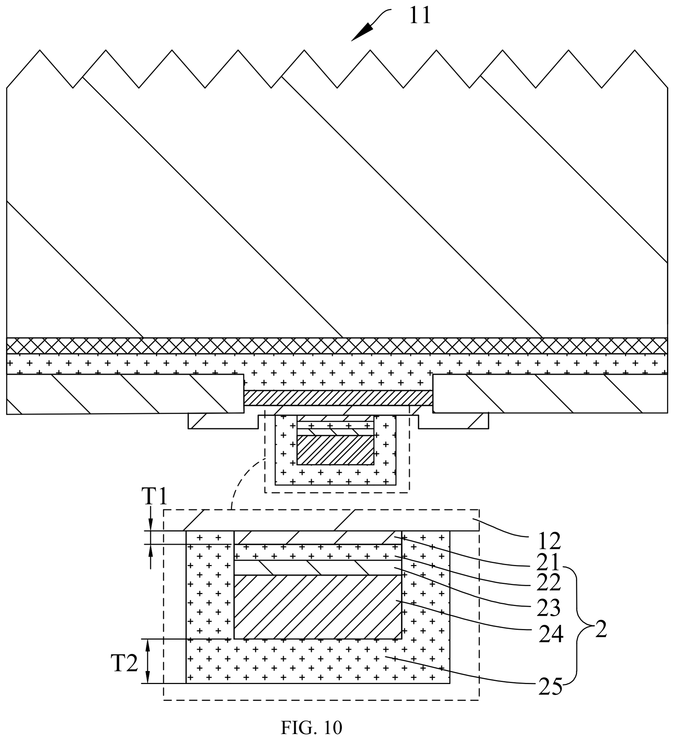

Referring to FIG. 9A and FIG. 10, an embodiment of the present disclosure discloses a back-contact PV module, including a plurality of electrically connected back-contact solar cells 1 and solder strips 2. Each solder strip 2 is soldered to each solder pad group M12.

In a soldering area of the solder strip 2 and the solder pad 12, the back-contact solar cell 1 includes the solder pad 12, a Ag-Sn alloy layer 21, a first Sn-Pb alloy layer 22, a conductive metal-Sn alloy layer 23, a conductive metal layer 24, and a second Sn-Pb alloy layer 25 that are stacked on the back-contact solar cell body 11 successively, along a direction away from the back-contact solar cell body 11.

The Ag-Sn alloy layer 21 has a thickness of T1, and the second Sn-Pb alloy layer 25 has a thickness of T2, and 2.5 < T2 / T1 < 300.

The following describes the beneficial effects of the back-contact PV module of the present disclosure.

In the present disclosure, the solder strip 2 can be placed at the overlapping notch 131, offset from the overlapping region of the two homopolar fingers 13a. This enables the solder strip 2 to be more precisely attached and soldered to the solder pad 12, and therefore it is not necessary to provide Sn solder paste filling between the solder strip 2 and the solder pad 12, or between the solder strip 2 and the finger 13.

Since the Sn solder paste can make the Ag-Sn alloy layer 21 too thick, the present disclosure omits Sn solder paste filling, resulting in a thinner thickness T1 of the Ag-Sn alloy layer 21. T1 satisfies the following relationship: 2.5 < T2 / T1 < 300. For example, T2 / T1 may be 2.6, 3, 10, 20, 30, 40, 50, 60, 80, 100, 150, 200, 250, or 299. A thinner Ag-Sn alloy layer 21 can reduce the usage of gridline material and simplify the manufacturing process, achieving the economic benefit of lower production costs without sacrificing the power density of the back-contact PV module.

In an embodiment, T1 is in a range from 0.1 µm to 10 µm, for example, 0.1 µm, 0.5 µm, 1 µm, 2 µm, 5 µm, 8 µm, or 10 µm. The Ag-Sn alloy layer 21 within this thickness range forms a good bond with the solder pad 12 after soldering, reducing pseudo soldering and desoldering. Further, the Ag-Sn alloy layer 21 within this thickness range is not excessively thick, which would waste the gridline material, thereby reducing costs and streamlining the manufacturing process.

It should be understood that since the present disclosure does not include Sn solder paste filling, the first Sn-Pb alloy layer 22 does not contain Bi, thus avoiding the usage of rare elements. This can significantly reduce the cost of industrialization, especially in the context of ultra-large-scale PV product market demand.

In an embodiment, the conductive metal layer 24 is made of at least one material selected from a group including Cu and Al. Cu and Al have low resistivity, which can reduce resistance transportation losses during current transportation in the back-contact PV module. Further, the low cost of Cu and Al can also reduce the production cost of PV products.

It should be noted that when the conductive metal layer 24 is Cu, the conductive metal-Sn alloy layer 23 is a Cu-Sn alloy layer. When the conductive metal layer 24 is Al, the conductive metal-Sn alloy layer 23 is an Al-Sn alloy layer.

In some embodiments, the solder strip 2 and finger 13 connected to the same solder pad 12 are spaced apart.

That is, the solder strip 2 is spaced apart from the overlapping region of the finger 13 and the solder pad 12. This allows the solder strip 2 to be better attached to the solder pad 12, which is thereby not necessary to fill Sn solder paste between the solder strip 2 and the solder pad 12.

In an embodiment, along the first direction X, the width of the overlapping notch 131 is W2, and the width of the solder strip 2 is W3, and W2>W3.

Thus, the width W2 of the overlapping notch 131 provides a margin for the offset of the solder strip 2, and the width W2 of the overlapping notch 131 can be adjusted based on the offset of the solder strip 2. Even if the solder strip 2 shifts, the solder strip 2 can still be spaced apart from the overlapping region between the finger 13 and the solder pad 12. Once positioned, the solder strip 2 can be attached to the solder pad 12, and thereby it is not necessary to fill Sn solder paste before soldering.

In contrast, conventional soldering processes often require filling Sn solder paste between the solder strip and the solder pad to ensure a good contact between the solder strip and the solder pad, in which the usage of Sn solder paste increases the manufacturing cost of the back-contact PV module.

Further, it is difficult for conventional soldering processes to achieve a spacing of D4 between the edge of the solder strip and the first solar cell edge which satisfies the requirement of 0.043% < D4/D2 < 0.870%. This is because, in conventional soldering processes, the pressing pin presses the solder strip onto the solder pad, placing a concentrated load on the solder pad. If the solder pad is close to the first solar cell edge, stress concentration further amplifies the external force which can easily lead to edge cracking. To avoid this edge soldering problem, the solder pad is typically positioned farther from the first solar cell edge.

Further, in conventional soldering processes, the offset of the solder strip is large, increasing the risk of cross-contact of the solder strip. To reduce the risk of short-circuiting, insulating adhesive is often applied between the solder pad group and the heteropolar finger.

In contrast, the soldering process in the present disclosure does not require a pressing pin to solder the solder strip onto the solder pad, thereby reducing the cracking risk occurred at edges of back-contact solar cell, and allowing the edge solder pad being closer to the first solar cell edge, and thus the edge solder strip can also be closer to the first solar cell edge. The spacing between the edge solder strip and the first solar cell edge, D4, satisfies 0.043% < D4/D2 < 0.870%.

Further, the soldering process of the present disclosure allows the solder strip to be wrapped around the top of the solder pad group with high precision, thereby effectively reducing or eliminating the risk of the solder strip to contact with the finger, without the need for printed polymer insulating adhesive. Further, the improved alignment accuracy between the solder strip and the solder pad group facilitates forming a surface contact between the solder strip and the solder pad group, ensuring good contact even without Sn solder paste filling therebetween.

The soldering process of the present disclosure is described in detail below.

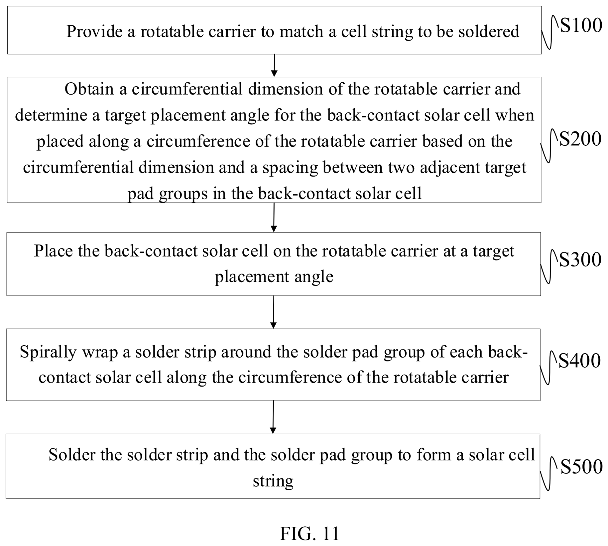

Referring to FIG. 11, some embodiments of the present disclosure provide a method for manufacturing a back-contact PV module, which may include the following steps of S100 to S500.

In step S100, a rotatable carrier is provided to match a cell string to be soldered. The cell string to be soldered includes a plurality of back-contact solar cells and a plurality of solder pad groups. The plurality of back-contact solar cells are arranged successively in the second direction. The plurality of solder pad groups are disposed on back-contact solar cell. The plurality of solder pad groups are arranged alternately spaced apart on the back surface of the back-contact solar cell body along the first direction. Each solder pad group includes a plurality of homopolar solder pads which are disposed spaced apart along the second direction. The first direction intersects with the second direction.

In step S200, a circumferential dimension of the rotatable carrier is obtained, and a target placement angle for the back-contact solar cell when placed along a circumference of the rotatable carrier is determined based on the circumferential dimension of the rotatable carrier and the spacing between two adjacent target solder pad groups of the back-contact solar cell.

In an embodiment, the rotatable carrier includes, but is not limited to, a cylindrical roller. The rotatable carrier is capable of uniformly rotating.

In an embodiment, the solder pad groups are all spaced apart at equal intervals in the first direction, and the target solder pad group may be any solder pad group.

In an embodiment, the spacing between at least some adjacent solder pad groups is different, and the target pad group may be selected from solder pad groups within a key region to meet requirements. For example, the back-contact solar cell includes a main region and an edge region. The spacing between adjacent solder pad groups in the main region is a first spacing, the spacing between adjacent solder pad groups in the edge region is a second spacing, and the first spacing and the second spacing are different. The two adjacent target solder pad groups may be any two solder pad groups within the main region.

In step S300, the back-contact solar cell is placed on the rotatable carrier at a target placement angle.

In an embodiment, the target placement angle of each back-contact solar cell may be determined individually.

In an embodiment, the back-contact solar cells have the same structure, and the target placement angle of each back-contact solar cells may be determined based on the target placement angle of any back-contact solar cell.

In an embodiment, the rotatable carrier can vacuum-absorb the back-contact solar cells to secure the back-contact solar cells on the rotatable carrier.

In step S400, a solder strip is spirally wrapped around the solder pad group of each back-contact solar cell along the circumference of the rotatable carrier.

In step S500, the solder strip and the solder pad group are soldered to form a solar cell string.

In this embodiment, the rotatable carrier is provided to match the cell string to be soldered. A target placement angle for the back-contact solar cells along the circumference of the rotatable carrier is determined based on the circumferential dimension of the rotatable carrier and the spacing between two adjacent target solder pad groups in the back-contact solar cells. The back-contact solar cells are then placed on the rotatable carrier at the target placement angle. The individual solder strip can then be spirally wrapped around the solder pad group of each back-contact solar cell along the circumference of the rotatable carrier to achieve proper alignment of the solder strip and the solder pad group, facilitating subsequent soldering of the solder strip and the solder pad group to form the solar cell string. Embodiments of the present disclosure establish a reference coordinate system based on the rotatable carrier. By predetermining the target placement angle, positioning the back-contact solar cells according to the target placement angle, and self-aligning and wrapping the solder strip, soldering is achieved between the solder strip and the solder pad group. This facilitates submillimeter-level alignment of the solder strip relative to the solder pad group, effectively eliminating inertial offset caused by the high-speed reciprocating movement of the plurality of solder strips by the robotic arm. This eliminates the need for insulating adhesive isolation and metal solder paste compensation, thereby increasing the number of solder pad groups, reducing the spacing between solder pad groups, and improving soldering accuracy. This enables a high-precision, low-resistance, and low-cost cell interconnection process, ensuring and improving the production yield and the long-term reliability of the back-contact PV module.

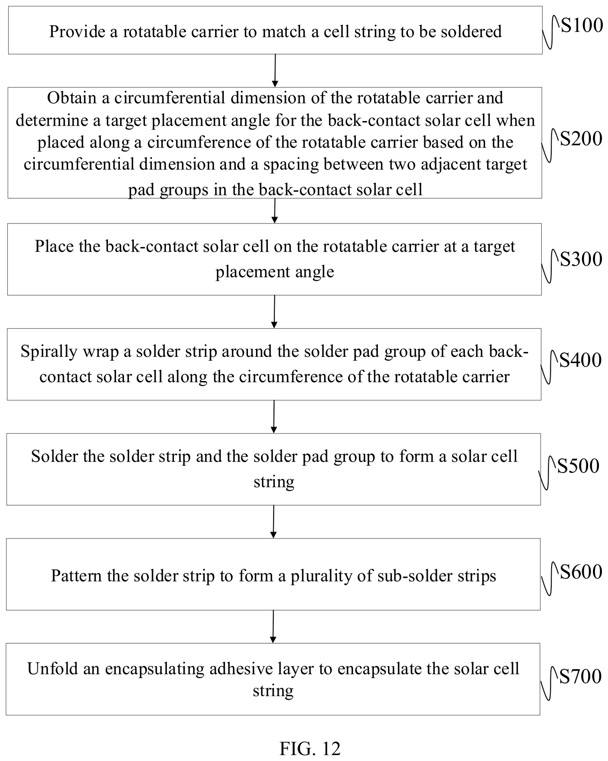

In some embodiments of the present disclosure, referring to FIG. 12, the manufacturing method of the back-contact PV module further includes step S600.

In step S600, the solder strip is patterned to form a plurality of sub-solder strips.

The connection between the sub-solder strips and the solder pad group is matched, the solder strip can be patterned to divide the solder strip into the plurality of sub-solder strips.

For example, the patterning process of the solder strip includes, but is not limited to, a cutting process.

In the embodiments of the present disclosure, after the individual solder strip is spirally wrapped around the solder pad group of each back-contact solar cell and the solder strip and the solder pad group are soldered together, the solder strip is cut to obtain the plurality of sub-solder strips. This avoids repeated solder strip alignment and soldering processes, thereby improving production efficiency and yield.

It should be noted that in some embodiments of the present disclosure, that the rotatable carrier is provided to match the cell string in step S100, and the following steps S110 to S 130 can be described as below.

In step S110, an unrolled length of the cell string to be soldered in the second direction is obtained.

The unrolled length of the cell string to be soldered may vary depending on the PV module layout of the cell string to be soldered.

In an embodiment, the unrolled length of the cell string to be soldered may range from, but is not limited to, 728mm to 1570 mm. For example, the unrolled length may be 728 mm, 1176 mm, or 1570 mm.

In step S120, a target circumference is determined based on the unrolled length; the target circumference is greater than or equal to the unrolled length.

In step S130, a rotatable carrier having a circumference as a target circumference is provided.

In this embodiment of the present disclosure, a rotatable carrier having a circumference greater than or equal to the unrolled length of the cell string to be soldered is provided. The cell string to be soldered may be unidirectionally unrolled and laid flat on the outer surface of the rotatable carrier, such that the individual solder strip can be spirally wrapped around the solder pad groups of each back-contact solar cell in the individual cell string to be soldered.

In some examples, only a single soldered cell string may be placed on the rotatable carrier. Alternatively, if the rotatable carrier has a larger axial dimension, a plurality of soldered cell strings may be placed spaced apart along its axial dimension, with each solder strip corresponding to each soldered cell string.

It is worth noting that in some embodiments, the material of the rotatable carrier is related to its rotational inertia. The target circumference may also be determined by combining the unrolled length of the cell string to be soldered and the material of the rotatable carrier in order to more accurately select the rotatable carrier.

In embodiments, the rotatable carrier is a cylindrical roller with a material density greater than 7 g/cm³, and may be made of a metal such as stainless steel or Al alloy. Furthermore, the cylindrical roller can be either a hollow roller or a solid roller.

In some examples, a radius of the cylindrical roller is defined as R, and a circumference is defined as C, and C = 2 *π* R, and R ≥ 115 mm.

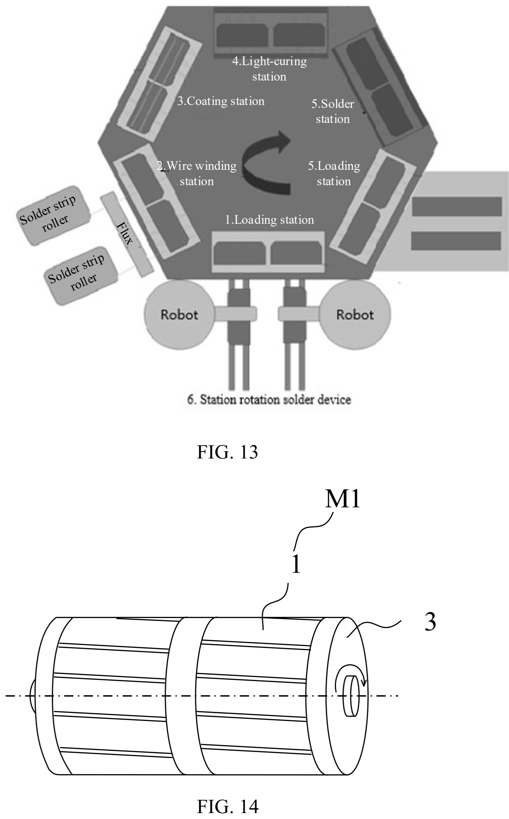

To clearly illustrate the manufacturing method of the back-contact PV module provided in the embodiment of the present disclosure, FIG. 13 provides an exemplary structural diagram of an automatic string soldering device. In the following embodiments, the manufacturing method of the back-contact PV module is described in detail with reference to the apparatus shown in FIG. 13.

Referring to FIG. 13 and FIG. 14, the rotatable carrier 3 can be provided at the loading station to match the cell string to be soldered M1, and after determining the target placement angle θ for the back-contact solar cell 1, the back-contact solar cell 1 is placed on the rotatable carrier 3 at the target placement angle θ. The target placement angle θ for the back-contact solar cell 1 can be determined in a variety of ways.

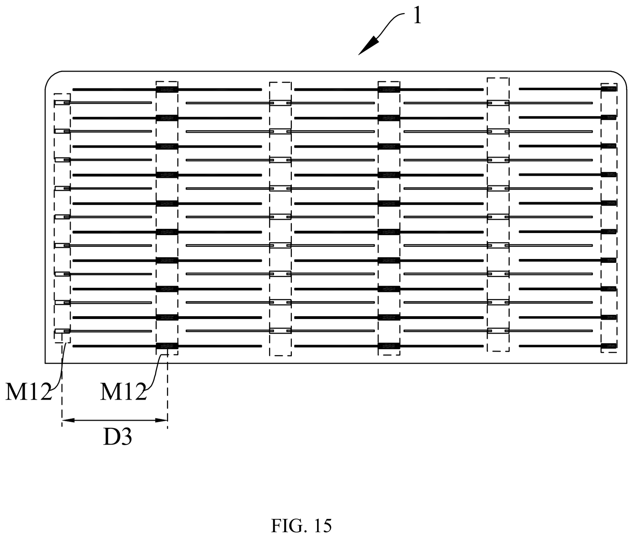

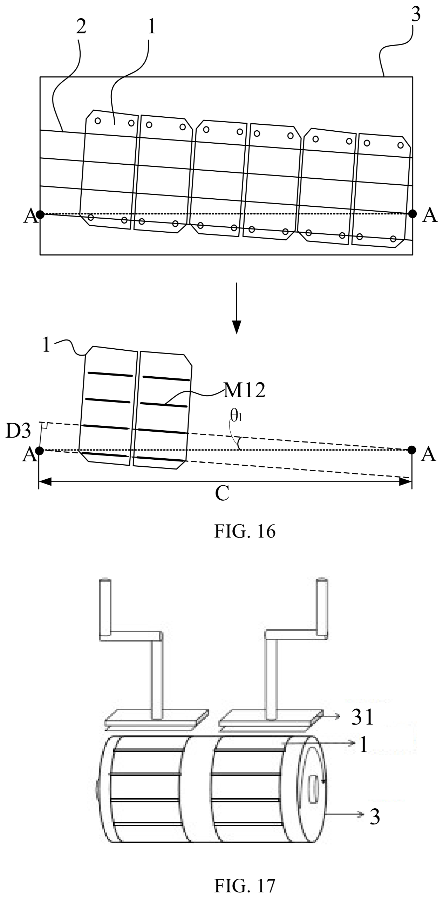

In some embodiments of the present disclosure, referring to FIG. 15 and FIG. 16, a target placement angle for the back-contact solar cell when placed along a circumference of the rotatable carrier is determined based on the circumferential dimension and a spacing between two adjacent target solder pad groups in the back-contact solar cell in step S200, the following steps S210 and S220 can be described as below.

In step S210, a spacing between two adjacent target solder pad groups is defined as D3, the circumferential dimension is defined as C, and the first included angle is defined as θ₁.

In step S220, the first included angle θ₁ is determined according to the formula: θ₁ = arcsin (D3/C); and the target placement angle θ is equal to the first included angle θ₁, i.e., θ = θ₁.

In some examples, taking the back-contact solar cell 1 shown in FIG. 15 as an example, the back-contact solar cell 1 is provided with a plurality of solder pad groups M12, and the plurality of solder pad groups M12 are, for example, spaced apart at equal intervals in the first direction. Assuming that each back-contact solar cell 1 in the cell string to be soldered M1 has been sequentially placed on a circumferential surface of rotatable carrier 3 at the target placement angle θ, as shown in FIG. 16, after the circumferential surface of rotatable carrier 3 is unfolded, the solder strip 2 is spirally wound around the solder pad groups M12 of each back-contact solar cell 1. The solder strip 2 can form a spiral path on the circumferential surface of the rotatable carrier 3 with a pitch of D3 and a lift angle of θ. In other words, the winding pitch of the solder strip 2 can be equal to the spacing between adjacent solder pad groups in the same back-contact solar cell 1. Further, the two points as shown in FIG. 16 are located at the same position when the circumferential surface of the rotatable carrier 3 is a columnar surface. Based on this, if the spacing between two adjacent target solder pad groups is defined as D3, the circumferential dimension of the rotatable carrier 3 is defined as C, and the first included angle is defined as θ₁, then first included angle θ₁ = arcsin(D3/C). In the present embodiment, setting the target placement angle θ equal to the first included angle θ₁ ensures that the individual solder strip is aligned and wound between each back-contact solar cell 1 and each solder pad group M12.

It should be understood that in some embodiments where the spacing between adjacent solder pad groups varies, after the back-contact solar cell 1 is positioned according to the target placement angle θ, the solder strip 2 can be spirally wound on the circumferential surface of the rotatable carrier 3, aligned with each solder pad group M12.

For example, 0° ≤ an absolute value of the target placement angle ≤ 1°.

The target placement angle, which matches the placement orientation of the back-contact solar cell 1 relative to the end surface edge of the rotatable carrier 3, can be positive or negative. For example, the target placement angle can be positive when the back-contact solar cell 1 is offset clockwise relative to the end surface edge of the rotatable carrier 3, and can be negative when the back-contact solar cell 1 is offset counterclockwise relative to the end surface edge of the rotatable carrier 3.

In some embodiments, the absolute value of the target placement angle ranges from 0.051° to 0.638°. For example, the target placement angle can be 0.051°, 0.087°, 0.195°, 0.389°, or 0.638°.

In some embodiments, assuming that the rotatable carrier 3 is a cylindrical roller with a radius R = 375 mm and the spacing D3 between two adjacent target solder pad groups in the same back-contact solar cell 1 is 8 mm, the target placement angle θ = θ₁ = 0.389° may be calculated using the formula θ₁ = arcsin(D3/C). Similarly, the target placement angle can be calculated based on the aforementioned formula for matching different values of the radius of the cylindrical roller and different values of the spacing between two adjacent target solder pad groups in the same back-contact solar cell 1.

In some embodiments of the present disclosure, the product of the spacing between two adjacent target solder pad groups in the same back-contact solar cell and the value of the number of the solder pad groups in the back-contact solar cell minus one is no greater than 230 mm.

In some embodiments, as shown in conjunction with FIG. 13 and FIG. 17, the back-contact solar cell 1 is typically absorbed and placed on the rotatable carrier 3 using a robotic arm 31 of a robot. Specifically, the robotic arm 31 typically uses visual positioning to determine the position data of the back-contact solar cell 1 and the position of the rotatable carrier 3 to position the back-contact solar cell 1. Then, the rotatable carrier 3 absorbs and fixes the back-contact solar cell 1.

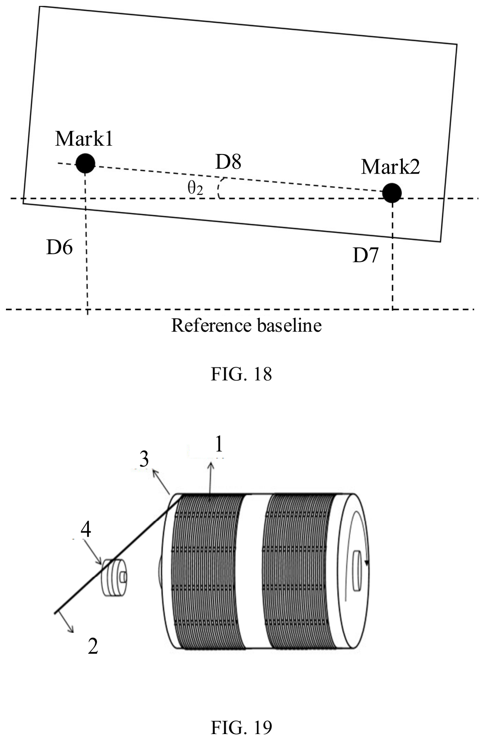

It should be understood that, since the robotic arm 31 typically has a small angular deviation in the positioning of the rotatable carrier 3 and when the robotic arm 31 picking up the solar cells. In other embodiments of the present disclosure, as shown in FIG. 18, a first marker Mark 1 and a second marker Mark 2 can be spaced apart on the back-contact solar cell 1 along the second direction (i.e., the direction in which the solder pad group extends). Based on the first marker Mark 1 and the second marker Mark 2, a first correction angle can be determined, so as to compensate for the angular deviation in the positioning of the rotatable carrier 3 and when the robotic arm 31 picking up the solar cells. The embodiment of the present disclosure does not impose any restrictions on the shape, material, or implementation of the first marker Mark 1 and the second marker Mark 2, as long as the first marker Mark 1 and the second marker Mark 2 can be measured and identified.

Accordingly, in step S200, that a target placement angle for the back-contact solar cell when placing around a circumference of the rotatable carrier is determined based on the circumferential dimension and the spacing between two adjacent target solder pad groups in the back-contact solar cell, include the following steps from S210' to S240'.

In step S210', the spacing between two adjacent target solder pad groups is defined as D3, the circumferential dimension of the rotatable carrier is defined as C, and the first included angle is defined as θ₁; and the first included angle θ₁ is determined using the formula: θ₁ = arcsin(D3/C).

In step S220', the back-contact solar cell on the rotatable carrier is placed according to the first included angle.

In step S230', the first spacing from the first marker to the reference baseline, the second spacing from the second marker to the reference baseline, and the third spacing between the first marker and the second marker are obtained, and the first correction angle is determined based on the first spacing, second spacing, and third spacing.

In an embodiment, the reference baseline is a virtual straight line extending parallel to the axis of the rotatable carrier. The reference baseline, the first marker Mark 1, and the second marker Mark 2 may lie in the same plane parallel to the back-contact solar cell surface.

In step S240', the target placement angle is determined based on the first included angle and the first correction angle.

For example, as shown in FIG. 18, that the first correction angle is determined based on the first spacing, second spacing, and third spacing in step S230' may include the following steps S231 to S233.

In step S231, the first spacing is defined as D6, the second spacing is defined as D7, the third spacing is defined as D8, the second included angle is defined as θ₂, and the first correction angle is defined as Δθ₁.

In step S232, the second included angle θ₂ is determined according to the formula θ₂= arcsin [(D6 - D7) / D8].

In step S233, the first correction angle Δθ₁ is determined according to the formula Δθ₁=θ₁ - θ₂.

Correspondingly, in step S240', the target placement angle θ is equal to the sum of the first included angle θ₁ and the first correction angle Δθ₁; that is, θ=θ₁+Δθ₁.

In the embodiment of the present disclosure, after placing the back-contact solar cell on the rotatable carrier at the first included angle, the actual placement angle of the back-contact solar cell (i.e., the second included angle θ₂) can be measured based on the first marker Mark 1 and the second marker Mark 2. This allows the first correction angle Δθ₁ to be determined based on Δθ1=θ₁-θ₂. As such, by compensating the first included angle θ₁ based on the first correction angle Δθ₁ to determine the target placement angle θ (i.e., θ = θ₁ + Δθ₁), the robotic arm can be controlled to place the back-contact solar cell at the target placement angle, ensuring that the actual placement angle of the back-contact solar cell is the first included angle θ₁. This ensures that the individual solder strip is aligned and wound between each back-contact solar cell 1 and the solder pad groups M12.

In an embodiment, the aforementioned compensation correction of the target placement angle θ based on the first correction angle Δθ₁ can be performed each time the robotic arm absorbs and places the back-contact solar cell.

As shown in conjunction with FIG. 13 and FIG. 19, after each back-contact solar cell 1 is placed at the loading station, the resulting structure can be sequentially transferred to the wire winding station. At the wire winding station, the individual solder strip 2 is first pulled and positioned by a solder strip gripper to the starting solder point of a busbar of the rotatable carrier 3. The rotatable carrier 3 is then controlled to rotate at a constant speed, while the solder strip arrangement mechanism is controlled to move in a constant linear motion. Guided by a guide mechanism 4, the solder strip gripper pulls the solder strip 2 wrapped around the solder pad groups of each back-contact solar cell 1. For example, the solder pad groups M12 in each back-contact solar cell 1 are spaced apart at equal intervals in the first direction. The solder strip 2 forms a spiral path with a pitch of D3 and a lift angle of θ on the circumferential surface of the rotatable carrier 3.

In some embodiments of the present disclosure, after the solder strip is spirally wrapped around the solder pad groups of each back-contact solar cell in step S400 and before the solder strip and the solder pad groups are soldered in step S500, the manufacturing method of the back-contact PV module may further include the following steps S410 and S420.

In step S410, curable adhesive is applied to a plurality of regions of the structure which is obtained after being wound by the solder strip; the regions to be applied by the curable adhesive extend along the first direction, and the regions to be applied by the curable adhesive are spaced apart along the second direction.

The number, location, and application processing of the regions to be applied by the curable adhesive can match the requirements and can be determined by adjusting parameters.

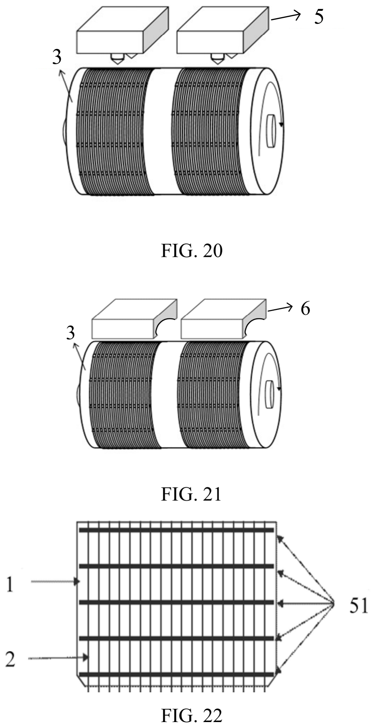

For example, as shown in conjunction with FIG. 13 and FIG. 20, after the solder strip 2 is wound, the resulting structure can be sequentially transferred to an adhesive-applying station. At the adhesive-applying station, the curable adhesive is applied to each region to be applied using adhesive application apparatus 5. The curable adhesive is a polymer fixing adhesive configured to fix the solder strip after being cured to prevent the solder strip from shifting before soldering.

In step S420, the curable adhesive is cured to form a cured adhesive strip; the cured adhesive strip connects the solder strip and the back-contact solar cell in a fixed manner.

In embodiments, the curing process for the curable adhesive includes a light-curing process or a heat-curing process.

In some examples, as shown in conjunction with FIG. 13 and FIG. 21, after applying the curable adhesive, the resulting structure can be sequentially transferred to a light-curing station. In the light-curing station, ultraviolet light is applied via a curing light box 6 to cure the curable adhesive and form a cured adhesive strip.

In other examples, the curing process for the curable adhesive is the heat-curing process, such as heating by infrared.

In embodiments, the heating temperature of the heat-curing process ranges from 100°C to 300°C, such as 100°C, 150°C, 200°C, or 300°C.

In some examples, the heating temperature of the heat-curing process ranges from 120°C to 150°C, such as 120°C, 130°C, 140°C, or 150°C.

In embodiments, the heating time of the heat-curing process ranges from 1 minute to 60 minutes, such as 1 minute, 5 minutes, 10 minutes, 30 minutes, 40 minutes, 50 minutes, or 60 minutes.

In some embodiments, the heating time of the heat-curing process ranges from 10 minutes to 30 minutes, such as 10 minutes, 15 minutes, 20 minutes, 25 minutes, or 30 minutes.

For example, as shown in FIG. 22, an extending direction of the cured adhesive strip 51 is perpendicular to the extending direction of solder strip 2. At least two curing adhesive strips 51 can be obtained for each wrap of solder strips 2.

In some embodiments of the present disclosure, that the solder strip and the solder pad group are soldered to form a solar cell string in step S500 include the following steps S510 and S520.

In step S510, the resulting structure after wounding the solder strip is placed in a heated environment.

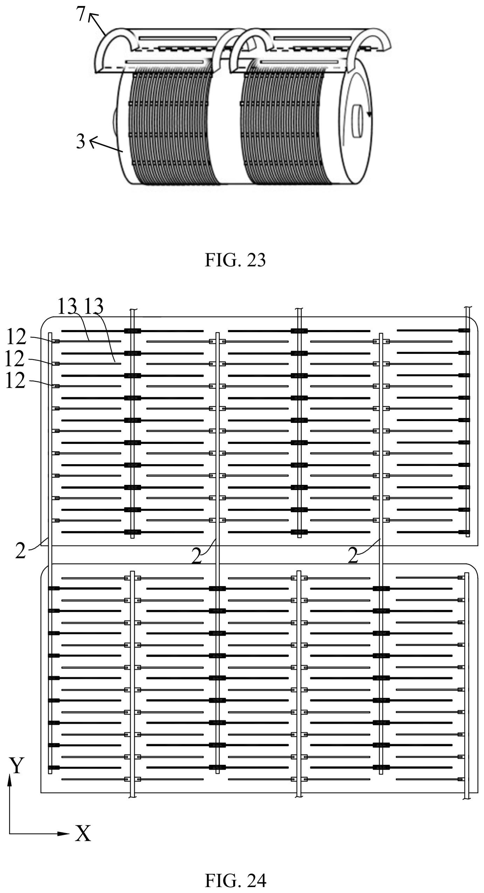

For example, as shown in conjunction with FIG. 13 and FIG. 23, after securing the solder strip 2, the resulting structure can be sequentially transferred to the solder station. At the solder station, a heating environment is provided by controlling the heating of an infrared light box 7.

In step S520, the solder strip is heated based on the heating environment to solder the solder strip onto the solder pad group, so as to form a solar cell string.

It should be understood that both the solder strip and the solder pad groups are made of metal. By heating the solder strip, a metallized connection (i.e., soldering) between the solder strip and the solder pad group is achieved.

In embodiments, the heating temperature provided by the heating environment ranges from 100°C to 500°C, such as 100°C, 120°C, 150°C, 250°C, 300°C, 400°C, or 500°C.

In some embodiments, the heating temperature provided by the heating environment ranges from 150°C to 250°C, such as 150°C, 180°C, 200°C, 220°C, or 250°C.

In embodiments, when the curing process for the curable adhesive is a heat-curing process, the heating structure used for the curable adhesive and the heating structure used for soldering the solder strip and the solder pad group can be the same infrared light box.

As discussed above, referring to FIG. 13, after soldering the solder strip and pad group, the resulting structure can be sequentially transferred to an unloading station for unloading the solar cell string.

As discussed above, the manufacturing method of the back-contact PV module provided in embodiments of the present disclosure can be completed in a station-by-station cycle using the automatic string soldering apparatus shown in FIG. 13. When the worktable in the automatic string soldering apparatus rotates to a designated station, the corresponding station is automatically triggered to perform an operation.

In some embodiments, the patterning process for the solder strip is performed after the solar cell string being unloaded from the unloading station.

In some embodiments, referring to FIG. 12, the manufacturing method of the back-contact PV module further includes the following step S700.

In step S700, an encapsulating adhesive layer is unfolded to encapsulate the solar cell string.

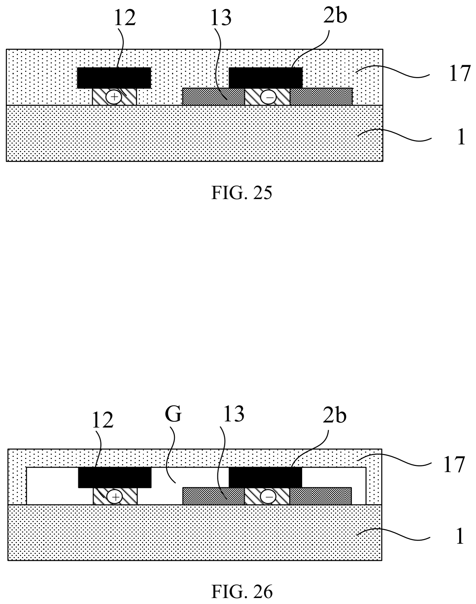

In embodiments, as shown in conjunction with FIG. 24 and FIG. 25, the back-contact solar cell 1 is provided with a plurality of fingers 13 connected to each solder pad 12 respectively. The plurality of fingers 13 extend along the first direction X and are spaced apart along the second direction Y. After the solder strip undergoes patterning processing, the center solder strip 2b is isolated from the fingers 13 which are connected to adjacent solder pads 12 by an encapsulating adhesive layer 17.

In embodiments, as shown in conjunction with FIG. 24 and FIG. 26, after the solder strip undergoes patterning processing, the center solder strip 2b is isolated from the fingers 13 which are connected to adjacent solder pads 12 by an encapsulating adhesive layer 17.

It should be added that after the solder strips and solder pad groups are soldered to form a solar cell string in step S500, the coating on the rotatable carrier (e.g., Teflon tape) and the positional tolerances between various mechanisms within the automated string soldering apparatus can easily introduce a stable system angular deviation within the solar cell string. This angular deviation is correlated with the target placement angle of the back-contact solar cell. That is, for the same back-contact solar cell placement, the system angular deviation is relatively stable. Accordingly, in some embodiments of the present disclosure, as shown in FIG. 24, the back-contact solar cell 1 is provided with a plurality of fingers 13 connected to each solder pad group M12. The plurality of fingers 13 extend along the first direction and are spaced apart, for example at equal intervals, along the second direction Y. Each finger 13 can, for example, be a gridline of equal length. The manufacturing method of the back-contact PV module may further include the following steps S710 to S740.

In step S710, the pad group to be tested is determined and two target fingers is selected from the fingers being connected to the solder pad group to be tested.

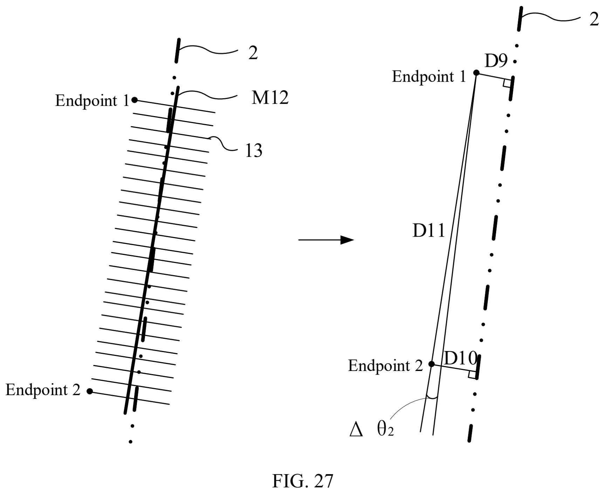

In step S720, the endpoint positions of the two target fingers located on the same side of the corresponding solder strip, which are defined as the first endpoint position and the second endpoint position, respectively, such as endpoint 1 and endpoint 2 shown in FIG. 27.

In step S730, the fourth distance from the first endpoint position to the corresponding solder strip, the fifth spacing from the second endpoint position to the corresponding solder strip, and the sixth spacing between the first endpoint position and the second endpoint position are obtained, respectively, and the second correction angle is determined based on the fourth spacing, the fifth spacing, and the sixth spacing.

In step S740, the target placement angle of the back-contact solar cell in the next cell string to be soldered is updated based on the second correction angle.

In some embodiments of the present disclosure, referring to FIG. 27, that the second correction angle is determined based on the fourth spacing, fifth spacing, and sixth spacing in step S730. The following steps S731 and S732 can be referred to as below.

In step S731, the fourth spacing is defined as D9, the fifth spacing is defined as D10, the sixth spacing is defined as D11, and the second correction angle is defined as Δθ₂.

In step S732, the second correction angle Δθ₂ is determined according to the formula Δθ₂ = arcsin [(D10 - D9) / D11].

Correspondingly, in step S740, the target placement angle θ' of the back-contact solar cell in the next cell string to be soldered is equal to the sum of the target placement angle θ of the back-contact solar cell in the current cell string to be soldered and the second correction angle Δθ₂; that is, θ' = θ + Δθ₂.

It should be understood that, in conjunction with the relevant descriptions in some of the aforementioned embodiments, that when the target placement angle θ for the back-contact solar cell in the current cell string to be soldered is equal to θ₁, the target placement angle θ' for the back-contact solar cell in the next cell string to be soldered θ' is equal to the sum of (θ₁ + Δθ₂). When the target placement angle θ for the back-contact solar cell in the current cell string to be soldered is equal to the sum of (θ₁ + Δθ₁), the target placement angle θ' for the back-contact solar cell in the next cell string to be soldered is equal to the sum of (θ₁ + Δθ₁ + Δθ₂).

In the embodiment of the present disclosure, after soldering is completed and the pad group to be tested and the two target fingers are determined, the second correction angle Δθ₂ can be determined based on the endpoint positions of the two target fingers on the same side of the corresponding solder strip, i.e., the spacing from endpoint 1 and endpoint 2 to the solder strip. Referring in conjunction with FIG. 27, the second correction angle Δθ₂ can effectively represent the relative deflection between the solder pad group M12 and the solder strip 2 under the influence of the system angular deviation. It should be noted that, for a better understanding, in FIG. 27, the solder pad group M12 is shown by its center line along the first direction.

As such, by compensating the target placement angle θ' of the back-contact solar cell in the next cell string to be soldered based on the second correction angle Δθ₂, the system angular deviation can be effectively compensated for during the manufacturing process of the next cell string to be soldered, further improving the alignment accuracy between the solder strip and the solder pad group M12.

In embodiments, the aforementioned compensation correction for the target placement angle θ' of the back-contact solar cell in the next cell string to be soldered based on the second correction angle Δθ₂ can be performed for the first cell string to be soldered in each batch of the cell strings to be soldered, or for a predetermined number of cell strings to be soldered. In other words, for the same batch of the cell strings to be soldered, the system angular deviation can be fully compensated in compensation correction of the angle of one or a few cell strings to be soldered.

In addition, that the solder pad group to be tested is determined in step S710 can be implemented using the following two implementations.

In some embodiments of the present disclosure, a regional averaging method can be used to determine the solder pad group to be tested. For example, that the solder pad group to be tested is determined in step S710 can include the following steps S711 and S712.

In step S711, the back-contact solar cell is divided into a plurality of inspection regions.

In step S712, a predetermined number of solder pad groups is selected within each inspection region, either randomly or according to a predetermined rule, as the solder pad groups to be tested respectively.

Accordingly, that the target placement angle of the back-contact solar cell in the next cell string to be soldered is updated based on the second correction angle in step S740, can be performed by updating the target placement angle of the back-contact solar cell in the next cell string to be soldered based on the average value of the second correction angles corresponding to each solder pad group to be tested. That is, in embodiments where there are a plurality of solder pad groups to be tested, the second correction angles corresponding to each solder pad group to be tested can be obtained one by one, and then the average value of each second correction angle can be calculated to update the target placement angle of the back-contact solar cell in the next cell string to be soldered based on the average of the second correction angles.

In other embodiments of the present disclosure, a specific location method can be used to determine the solder pad group to be tested. For example, that the solder pad group to be tested is determined in step S710 can be performed by selecting the solder pad group to be tested in a key region of the back-contact solar cell. The key region includes a starting region or a middle region where the solder pad groups are arranged along a winding direction of the solder strip. That is, along the winding direction of the solder strip, the first pad group to be tested can be the solder pad group to be tested, or one or more solder pad groups located in the middle region can be the solder pad group to be tested. It should be understood that in the example where there are a plurality of solder pad groups, the second correction angle can be the average of the second correction angles corresponding to the solder pad groups to be tested.

As described above, the embodiments of the present disclosure can converge the solder strip landing point error to within ±0.15 mm through dynamic iterative correction of the target placement angle of the back-contact solar cell. That is, the maximum offset between a center line of the solder strip and a center line of the solder pad group is no more than 0.15 mm.

In some embodiments, the landing point error of the solder strip can be converged to within ±0.10 mm; that is, the maximum offset between the center line of the solder strip and the center line of the solder pad group is no more than 0.10 mm.

In some embodiments, the landing point error of the solder strip can be converged to within ±0.05mm; that is, the maximum offset between the center line of the solder strip and the center line of the solder pad group is no more than 0.05 mm.

In addition, in some embodiments of the present disclosure, a width of the solder strip is ≥0.1 mm; for example, it can be 0.1 mm, 0.2 mm, 0.3 mm, 0.5 mm, 0.6 mm or 1.0 mm.

In summary, the manufacturing method of the back-contact PV module provided in the embodiments of the present disclosure can have the following technical advantages (1) to (7).
(1) The alignment accuracy between the solder strip and the solder pad group is significantly improved. For example, in the embodiment of the present disclosure, the solder strip is spirally wound and the target placement angle of the back-contact solar cell is dynamically corrected, which can converge the landing point error of the solder strip to within ±0.15mm, or even within ±0.05mm.
(2) The number of the busbars is not limited. For example, in embodiments of the present disclosure, the individual solder strip can be wound to cover all solder pad groups, without the physical constraints of the solder head width and the solder strip supply channel, and can easily support the high-density design with solder pad groups greater than or equal to 30, leaving enough margin for improving the efficiency of the back-contact PV module.
(3) The series resistance and the power loss are effectively reduced. For example, the embodiment of the present disclosure do not apply insulation adhesive isolation and metal solder refill, ensuring a single and dense interface between the solder strip and the solder pad group, thereby reducing the series resistance and the power loss.
(4) The solder process is simplified and the production efficiency is improved. In the embodiment of the present disclosure, the production process from three steps of " adhesive-printing - curing - solder reflowing" is reduced to a one-step continuous wire winding soldering process, which can improve production efficiency and simultaneously reduce BOM cost and energy consumption.
(5) There is no need for insulation adhesive isolation and metal solder refill. For example, in the embodiment of the present disclosure, the solder strip can be wound on the top of the solder pad group with high precision, effectively reducing or eliminating the risk of solder strip being cross-contacted, without the need for printing polymer insulation adhesive, and without the need for a secondary metal solder refill process due to the step difference of the insulation adhesive.
(6) The long-term reliability of the solar cell string is enhanced. The embodiments of the present disclosure do not involve organic adhesive volatilization and secondary heterogeneous solder joints, which can have better thermal-mechanical matching in the solder interface. In addition, the current density of the solder strip can be reduced due to the increase in the number of solder pad groups, and the risk of hot spots can be reduced.
(7) The manufacturing method is more environmentally friendly and safe. The embodiments of the present disclosure do not use solvent-based insulating adhesives, which can avoid the emission pollution of volatile organic compounds (VOC) and the treatment of workshop odors; the embodiments of the present disclosure do not use metal solder refill, which reduces the solder usage and can reduce the potential exposure of metals such as Pb and Bi.

## Claims

1. A back-contact solar cell (1), comprising:
a back-contact solar cell body (11);
a plurality of solder pad groups (M12) of two polarities alternately spaced apart along a first direction (X) on a back surface of the back-contact solar cell body (11), each solder pad group (M12) comprising a plurality of pads (12) of the same polarity spaced apart along a second direction (Y), and the first direction (X) intersecting with the second direction (Y); and
a plurality of fingers (13) of two polarities arranged on the back surface of the back-contact solar cell body (11), and each solder pad (12) being connected to at least one finger (13) of the same polarity and being spaced apart from fingers (13) of opposite polarity;
wherein the back-contact solar cell body (11) has two first solar cell edges (101) arranged opposite to each other along the first direction (X), a solder pad (12) in the plurality of solder pad groups (M12) closest to each first solar cell edge (101) is defined as an edge solder pad (12a), a spacing between the edge solder pad (12a) and the closest first solar cell edge (101) is D1, a length of the back-contact solar cell body (11) in the first direction (X) is D2, and 0.043% < D1/D2 < 0.870%.

2. The back-contact solar cell (1) according to claim 1, wherein 0.1 mm < D1 < 2 mm, optionally, 0.1 mm < D1 < 1 mm.

3. The back-contact solar cell (1) according to claim 1, wherein the edge solder pad (12a) and the finger (13) form a direct electrical connection;
and/or, wherein only an end of the edge solder pad (12a) away from the closest first solar cell edge (101) along the first direction (X) is connected to the finger (13); and on the back surface of the back-contact solar cell body (11), a region between the edge solder pad (12a) and the closest first solar cell edge (101) is a gridline-free region.

4. The back-contact solar cell (1) according to claim 1, further comprising a plurality of busbars (14) extending along the second direction (Y), wherein each busbar (14) is connected to all of the solder pads (12) in each solder pad group (M12); or each busbar (14) is connected to a part of the solder pads (12) in each solder pad group (M12);
or, wherein the back-contact solar cell (1) is a busbar-free solar cell.

5. The back-contact solar cell (1) according to claim 4, wherein when the back-contact solar cell (1) comprises the plurality of busbars (14), a total orthographic projection area of the plurality of busbars (14) and the solder pads (12) on the back-contact solar cell body (11) is S1, an area of the back surface of the back-contact solar cell body (11) is S2, and 0.05% ≤ S1/S2 ≤ 6.2%;
when the back-contact solar cell (1) is the busbar-free solar cell, a total orthographic projection area of the solder pads (12) on the back-contact solar cell body (11) is S1, the area of the back surface of the back-contact solar cell body (11) is S2, and 0.05% ≤ S1/S2 ≤ 6.2%.

6. The back-contact solar cell (1) according to any one of claims 1 to 5, wherein each finger (13) extends along the first direction (X), and the plurality of fingers (13) of two polarities are arranged alternately in a column along the second direction (Y);
wherein a plurality of columns of the fingers (13) are spaced apart along the first direction (X), and a discontinuity region is provided between adjacent columns of the fingers (13);
wherein except for the edge solder pads (12a), each of the remaining solder pad groups (M12) is located in each discontinuity region, and the solder pads (12) in the remaining solder pad groups (M12) are defined as inner solder pads (12b);
wherein on both sides of each discontinuity region, the fingers (13) having the same polarity as the inner solder pads (12b) are defined as homopolar fingers (13a); along the first direction (X), an overlapping notch (131) is provided between two adjacent homopolar fingers (13a), each inner solder pad (12b) is located in each overlapping notch (131), and both ends of the inner solder pad (12b) overlaps with the two homopolar fingers (13a), respectively.

7. The back-contact solar cell (1) according to claim 6, wherein on both sides of each discontinuity region, the fingers (13) having opposite polarity to the inner solder pad (12b) are defined as heteropolar fingers (13b); along the first direction (X), an isolating notch (132) is provided between two heteropolar fingers (13b); and along the first direction (X), a width W1 of the isolation notch (132) is greater than a width W2 of the overlapping notch (131);
and/or, 0.3mm < W1≤ 1.2mm;
and/or, 0.15 mm≤W2≤0.7 mm.

8. The back-contact solar cell (1) according to claim 7, wherein along the first direction (X), a width of a solder strip (2) is W3, and W1>W3;
and/or, along the first direction (X), a width of the solder strip (2) is W3, and W2>W3.

9. The back-contact solar cell (1) according to any one of claims 1 to 8, wherein the solder pad (12) have a shape selected from a group consisting of a square, a diamond, an oval, a H-shape, a T-shape, or a trapezoid;
and/or, wherein a number of the solder pad groups (M12) is greater than or equal to 30 and less than or equal to 120;
and/or, wherein a spacing between two adjacent solder pad groups (M12) is D3, and 1.5 mm ≤ D3 ≤ 8 mm.

10. A back-contact PV module, comprising:
a plurality of back-contact solar cells electrically connected to each other, at least one of the plurality of back-contact solar cells being the back-contact solar cell (1) according to any one of claims 1 to 9; and
a plurality of solder strips (2), each solder strip (2) being soldered to each solder pad group (M12), a solder strip (2) soldered to the edge solder pads (12a) being defined as an edge solder strip (2a), wherein a spacing between the edge solder strip (2a) and the first solar cell edge (101) is D4, and 0.043% < D4/D2 < 0.870%.

11. The back-contact PV module according to claim 10, wherein 0.1 mm < D4 < 2 mm, optionally, 0.1 mm < D4 < 1 mm.

12. The back-contact PV module according to any one of claims 10 to 11, wherein along the second direction (Y), the back-contact solar cell body (11) has two second solar cell edges (103) opposite to each other along the second direction (Y), a solder position of the solder strip (2) closest to the second solar cell edge (103) is defined as a starting solder point (201), a spacing between the starting solder point (201) and the closest second solar cell edge (103) is D5, and 0.5 mm ≤ D5 ≤ 7 mm.

13. A back-contact PV module, comprising:
a plurality of back-contact solar cells electrically connected to each other, at least one of the plurality of back-contact solar cells being the back-contact solar cell (1) according to any one of claims 1 to 9; and
a plurality of solder strips (2), each solder strip (2) being soldered to each solder pad group (M12), along the first direction (X), each solder pad group (M12) being spaced apart from an adjacent finger (13) of opposite polarity, and no insulating adhesive is provided therebetween.

14. A back-contact PV module, comprising:
a plurality of back-contact solar cells electrically connected to each other, at least one of the plurality of back-contact solar cells being the back-contact solar cell (1) according to any one of claims 1 to 9; and
a plurality of solder strips (2), each solder strip (2) being soldered to each solder pad group (M12);
wherein in a solder region between the solder strip (2) and the solder pad (12), in a direction away from the back-contact solar cell body (11), the back-contact solar cell (1) further comprises a solder pad (12), a Ag-Sn alloy layer (21), a first Sn-Pb alloy layer (22), a conductive metal-Sn alloy layer (23), a conductive metal layer (24), and a second Sn-Pb alloy layer (25) that are stacked on the back-contact solar cell body (11) sequentially;
wherein the Ag-Sn alloy layer (21) has a thickness of T1, the second Sn-Pb alloy layer (25) has a thickness of T2, and 2.5 < T2/T1 < 300.

15. The back-contact PV module according to claim 14, wherein T1 is in a range from 0.1 µm to 10 µm;
and/or, the first Sn-Pb alloy layer (22) does not contain Bi;
and/or, the conductive metal layer (24) is made of at least one material selected from a group consisting of Cu and Al.
